# EUROPEAN PATENT SPECIFICATION

(11) **EP 2 623 526 B1**
(45) Date of publication and mention of the grant of the patent: **26.07.2017**
(21) Application number: 11829261.4
(22) Date of filing: 29.09.2011
(51) Int. Cl.: C08F 8/42, B32B 25/14, C08F 297/04, C09K 3/10, H01L 31/042

(54) **HYDROGENATED BLOCK COPOLYMER HAVING ALKOXYSILYL GROUP, AND USE THEREFOR**
HYDRIERTES BLOCKCOPOLYMER MIT EINER ALKOXYSILYLGRUPPE UND VERWENDUNG DAFÜR
COPOLYMÈRE BLOC HYDROGÉNÉ COMPRENANT UN GROUPE ALCOXYSILYLE ET SON UTILISATION

(30) Priority: 23.03.2011 JP 2011063435; 29.09.2010 JP 2010218074
(43) Date of publication of application: 07.08.2013
(73) Proprietor: Zeon Corporation, Tokyo 100-8246 (JP)
(72) Inventor: KOHARA Teiji, Tokyo 100-8246 (JP); ISHIGURO Atsushi, Tokyo 100-8246 (JP); KURIHARA Ryuta, Tokyo 100-8246 (JP)
(74) Representative: Maiwald Patentanwalts GmbH
(86) International application number: PCT/JP2011/072348
(87) International publication number: WO 2012/043708

(56) References cited:
- WO-A1-2009/151029
- WO-A1-2009/151029
- WO-A1-2011/068188
- WO-A1-2011/096389
- WO-A2-2006/093936
- JP-A- 1 210 410
- JP-A- 62 218 468
- JP-A- 2002 235 048
- JP-A- 2003 155 385
- JP-A- 2003 201 312
- JP-A- 2005 019 975
- JP-A- 2006 328 410
- US-A1- 2006 142 490

## Description

### TECHNICAL FIELD

The invention relates to an alkoxysilyl group-containing hydrogenated block copolymer that may suitably be used as an encapsulating material that encapsulates solar cell elements included in a solar cell module, a method for producing the alkoxysilyl group-containing hydrogenated block copolymer, a solar cell element encapsulating material, a sheet that includes the solar cell element encapsulating material, a laminated sheet, a multilayer sheet, and a method for encapsulating a solar cell.

### BACKGROUND ART

In recent years, a solar cell that utilizes clean energy has attracted attention, and various solar cell modules have been developed. A solar cell module that utilizes a monocrystalline or polycrystalline silicon device (i.e., a solar cell module that includes a crystalline solar cell (solar cell element or device)), a solar cell module that utilizes a thin-film amorphous silicon device (i.e., a solar cell module that includes an amorphous solar cell), and the like have been the mainstream.

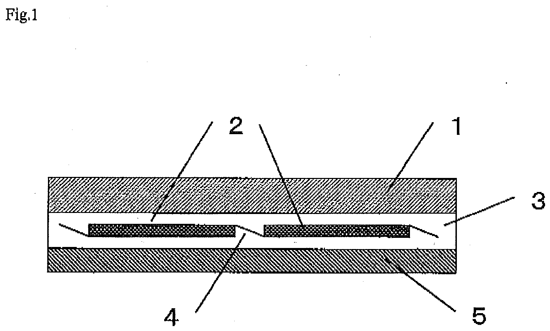

As illustrated in FIG. 1, a solar cell module may include (from the sunlight incident side) a transparent front substrate 1 (e.g., glass substrate), solar cell elements 2, an encapsulating material 3 that encapsulates the solar cell elements, a wire 4 connected to the solar cell elements, and a backsheet 5. An encapsulating material formed of a cured product obtained by crosslinking and curing an ethylene-vinyl acetate copolymer (EVA) using a crosslinking agent (e.g., organic peroxide) has been widely used as the encapsulating material 3 that encapsulates the solar cell elements.

A known solar cell has the following problems. Specifically, when a solar cell is used for a long time in an outdoor high-humidity/temperature environment in which the solar cell is weathered, moisture or water may enter the solar cell, and decrease the insulating properties of the encapsulating material, so that the durability of the solar cell may deteriorate. A cured product of EVA that is used as the encapsulating material exhibits excellent transparency and light resistance. However, since EVA contains a repeating unit derived from vinyl acetate, EVA may be hydrolyzed with the passage of time due to moisture or water to produce acetic acid, which may come in contact with the wire or the electrode provided in the solar cell, and accelerate corrosion of the wire or the electrode.

In order to improve the durability of the solar cell by preventing a decrease in insulating properties due to moisture or water that has entered the solar cell, corrosion of the wire or the electrode, and the like, a method that stacks an evaporated layer of an inorganic oxide on the backsheet as a barrier layer (e.g., Patent Document 1), a method that utilizes a cycloolefin resin sheet having a low water vapor permeability as the backsheet (e.g., Patent Documents 2 and 3), and the like have been proposed.

However, these methods cannot completely prevent entrance of moisture or water.

In order to solve the problem caused by an acid produced due to hydrolysis of the encapsulating material, a method that adds an acid acceptor to a cured product of EVA, or a method that introduces a substituent that reacts with an acid into a cured product of EVA (e.g., Patent Documents 4 and 5) have been proposed.

These methods can reduce the effects of production of an acid. However, since a cured product of EVA has high hygroscopicity and moisture transmission properties, it is difficult to sufficiently prevent corrosion of the wire or the electrode provided in the solar cell due to water that has entered the solar cell from the outside.

A method that utilizes an encapsulating resin that does not produce an acid through hydrolysis instead of a cured product of EVA (e.g., a method that utilizes an ethylene-α-olefin copolymer and a crosslinking agent (Patent Documents 6 and 7), and a method that utilizes a propylene polymer and a specific propylene copolymer (Patent Document 8)), have also been proposed.

The resins used in these methods have low hygroscopicity and moisture transmission properties, and may reduce the effects of an acid. However, since the balance between the heat resistance and the flexibility of the encapsulating resin is poor, and excellent heat resistance is not achieved when the encapsulating resin is not crosslinked, it is necessary to perform a crosslinking step when producing a solar cell element encapsulating sheet.

Patent Document 9 discloses that a block copolymer obtained by hydrogenating the carbon-carbon double bonds of a prepolymer that includes at least three blocks including a hard block that contains a repeating unit derived from an aromatic vinyl monomer as the main component, and a soft block that contains a repeating unit derived from a conjugated diene as the main component, has high thermal deformation resistance, good mechanical properties, high transparency, and low water absorption, and may be used as a cover for protecting a system (e.g., solar cell) that is easily mechanically damaged. Patent Document 9 does not suggest using the block copolymer as a solar cell element encapsulating material.

Patent Document 10 discloses that a vinyl alicyclic hydrocarbon polymer obtained by hydrogenating carbon-carbon double bonds may be used for various applications including an electric/electronic part encapsulating material.

The polymer disclosed in Patent Document 10 is a block polymer that does not contain a conjugated diene block, and has a high aromatic vinyl monomer content. Patent document WO2009151029 describes a sealing material used for sealing material sheet for solar cell module and having, as constituent components, (i) polypropylene, (ii) hydrogenated diene-based polymer and (iii) a polymer (a functional-group-containing polymer) which is different from said component (ii) and has at least one type of functional group. The material includes 1 to 100 parts by mass of component (iii) with respect to 100 parts by mass in total comprising 0 to 60 parts by mass of component (i) and 40 to 100 parts by mass of component (ii).

Patent document WO-A-2006/093936 relates to a solar cell encapsulating material that has improved photothermal and photochemical stability and comprising a polymeric encapsulating material such as an ionomer, EVA or a block polymer, a UV absorber and a hindered amine light stabilizer.

Patent Document US-A-2006/0142490 describes an economical filler layer for a solar cell module which is excellent in the adhesion property to a transparent front substrate and a backside protective sheet. To accomplish the aim, the invention provides a filler layer for a solar cell module containing a silane-modified resin obtained by polymerizing an ethylenic unsaturated silane compound and a polyethylene for polymerization and characterized in that the filler layer for a solar cell module has a gel fraction of 30% or lower when the filler layer for a solar cell module is used in a solar cell module.

### RELATED-ART DOCUMENT

### PATENT DOCUMENT

Patent Document 1: JP-A-2000-91610
Patent Document 2: JP-A-2000-106450
Patent Document 3: JP-A-2001-44481
Patent Document 4: JP-A-2005-29588
Patent Document 5: JP-A-2008-291222
Patent Document 6: JP-A-6-299125
Patent Document 7: JP-A-2000-91611
Patent Document 8: WO2008/015984 (US2010/0006600A1)
Patent Document 9: JP-T-2002-531598 (WO2000/032646)
Patent Document 10: WO2002/016447

### SUMMARY OF THE INVENTION

### TECHNICAL PROBLEM

The invention was conceived in view of the above situation. An object of the invention is to provide a hydrogenated block copolymer that may be useful as a solar cell element encapsulating material that exhibits low hygroscopicity, non-hydrolyzability, weatherability, transparency, and flexibility, maintains excellent adhesion to glass even when exposed to a high-temperature/high-humidity environment for a long time, and can encapsulate a solar cell element without applying a special waterproof treatment, a method for producing the hydrogenated block copolymer, a solar cell element encapsulating material, a sheet that includes the solar cell element encapsulating material, a laminated sheet, a multilayer sheet, and a method for encapsulating a solar cell element.

### SOLUTION TO PROBLEM

The inventors of the invention attempted to use the block copolymer disclosed in Patent Document 9 that has a high aromatic vinyl monomer content as a solar cell element encapsulating material, and found that the block copolymer disclosed in Patent Document 9 has low flexibility and a low encapsulating capability, and cracks easily occur in the polymer layer (i.e., the block copolymer disclosed in Patent Document 9 is not suitable as an encapsulating material).

The inventors conducted studies in order to solve the above problem, and modified a hydrogenated block copolymer obtained by hydrogenating the carbon-carbon unsaturated bonds of a block copolymer that includes a specific polymer block with an ethylenically unsaturated silane compound in the presence of an organic peroxide to obtain a modified polymer. The inventors found that a resin composition that includes the modified polymer exhibits low hygroscopicity, non-hydrolyzability, weatherability, transparency, and flexibility, maintains excellent adhesion to glass even when exposed to a high-temperature/high-humidity environment for a long time, and can encapsulate a solar cell element without applying a special waterproof treatment.

The inventors conducted further extensive studies, and found that, when encapsulating a solar cell element by a vacuum lamination process using the modified polymer of the specific hydrogenated block copolymer as the encapsulating material, the solar cell element (particularly a crystalline solar cell element) easily cracks unless the solar cell element is encapsulated at a high temperature as compared with the case of using a cured product of EVA as the solar cell element encapsulating material. When using a cured product of EVA as the encapsulating material, the encapsulating temperature is normally 150°C or less. In contrast, the encapsulating temperature must normally be increased to 160°C or more when using the modified polymer of the specific hydrogenated block copolymer as the encapsulating material.

The inventors conducted still further extensive studies in order to solve the above problem, and found that it is possible to prevent a situation in which the solar cell element (particularly a crystalline solar cell element) cracks even if the solar cell element is encapsulated at a lower temperature, by utilizing a (multilayer sheet obtained by stacking a layer [I] that includes the modified polymer of the specific hydrogenated block copolymer and a layer [II] that includes a modified polymer obtained by introducing an alkoxysilyl group into an olefin (co)polymer having a specific melting point. These findings have led to the completion of the invention.

Several aspects of the invention may provide the following alkoxysilyl group-containing hydrogenated block copolymer (see (1) to (3)), method for producing an alkoxysilyl group-containing hydrogenated block copolymer (see (4)), solar cell element encapsulating material (see (5) to (8)), sheet (see (9)), laminated sheet (see (10)), a multilayer sheet (see (11) to (14)), and method for encapsulating a solar cell element (see (15)).
(1) An alkoxysilyl group-containing hydrogenated block copolymer produced by introducing an alkoxysilyl group into a hydrogenated block copolymer that is obtained by hydrogenating 90% or more of the carbon-carbon unsaturated bonds of the main chain, the side chain and the aromatic ring of a block copolymer that includes at least two polymer blocks [A] and at least one polymer block [B], the polymer block [A] including a repeating unit derived from an aromatic vinyl compound as a main component, the polymer block [B] including a repeating unit derived from a linear conjugated diene compound as a main component, and a ratio (wA:wB) of a weight fraction wA of the polymer block [A] in the block copolymer to a weight fraction wB of the polymer block [B] in the block copolymer being 20:80 to 60:40.
(2) An alkoxysilyl group-containing hydrogenated block copolymer produced by introducing an alkoxysilyl group into a hydrogenated block copolymer that is obtained by hydrogenating 90% or more of the carbon-carbon unsaturated bonds of the main chain, the side chain and the aromatic ring of a block copolymer that includes at least two polymer blocks [A] and at least one polymer block [B], the polymer block [A] including a repeating unit derived from an aromatic vinyl compound as a main component, the polymer block [B] including a repeating unit derived from a linear conjugated diene compound as a main component, and a ratio (wA:wB) of a weight fraction wA of the polymer block [A] in the block copolymer to a weight fraction wB of the polymer block [B] in the block copolymer being 40:60 to 60:40.
(3) A method for producing the alkoxysilyl group-containing hydrogenated block copolymer according to (1), the method including reacting an ethylenically unsaturated silane compound with a hydrogenated block copolymer in the presence of an organic peroxide, the hydrogenated block copolymer being obtained by hydrogenating 90% or more of the carbon-carbon unsaturated bonds of the main chain, the side chain and the aromatic ring of a block copolymer that includes at least two polymer blocks [A] and at least one polymer block [B], the polymer block [A] including a repeating unit derived from an aromatic vinyl compound as a main component, the polymer block [B] including a repeating unit derived from a linear conjugated diene compound as a main component, and a ratio (wA:wB) of a weight fraction wA of the polymer block [A] in the block copolymer to a weight fraction wB of the polymer block [B] in the block copolymer being 20:80 to 60:40.
(4) The method according to (3), wherein the ethylenically unsaturated silane compound is at least one ethylenically unsaturated silane compound selected from a group consisting of vinyltrimethoxysilane, vinyltriethoxysilane, allyltrimethoxysilane, allyltriethoxysilane, dimethoxymethylvinylsilane, diethoxymethylvinylsilane, p-styryltrimethoxysilane, and p-styryltriethoxysilane.
(5) A solar cell element encapsulating material including the alkoxysilyl group-containing hydrogenated block copolymer according to (1) or (2).
(6) The solar cell element encapsulating material according to (5), further including a hindered amine light stabilizer in an amount of 0.1 to 10 parts by weight based on 100 parts by weight of the alkoxysilyl group-containing hydrogenated block copolymer.
(7) The solar cell element encapsulating material according to (5), further including a UV absorber in an amount of 0.01 to 0.1 parts by weight based on 100 parts by weight of the alkoxysilyl group-containing hydrogenated block copolymer.
(8) The solar cell element encapsulating material according to (5), further including a phosphorus-based antioxidant in an amount of 0.01 to 0.1 parts by weight based on 100 parts by weight of the alkoxysilyl group-containing hydrogenated block copolymer.
(9) A sheet including the solar cell element encapsulating material according to any one of (5) to (8).
(10) A laminated sheet including a sheet that is formed of a resin composition, and the sheet according to (9) that is stacked on one side or each side of the sheet that is formed of the resin composition, the resin composition including (α) a hydrogenated block copolymer, and (β) at least one component selected from a group consisting of a polymer other than the hydrogenated block copolymer (α) that includes an alkoxysilyl group, a light stabilizer, a UV absorber, and an antioxidant, the hydrogenated block copolymer being obtained by hydrogenating 90% or more of the carbon-carbon unsaturated bonds of the main chain, the side chain and the aromatic ring of a block copolymer that includes at least two polymer blocks [A] and at least one polymer block [B], the polymer block [A] including a repeating unit derived from an aromatic vinyl compound as a main component, the polymer block [B] including a repeating unit derived from a linear conjugated diene compound as a main component, and a ratio (wA:wB) of a weight fraction wA of the polymer block [A] in the block copolymer to a weight fraction wB of the polymer block [B] in the block copolymer being 20:80 to 60:40.
(11) A multilayer sheet including [I] a layer that includes the alkoxysilyl group-containing hydrogenated block copolymer (i) according to (2), and [II] a layer that includes a (co)polymer (ii) that is obtained by introducing an alkoxysilyl group into a (co)polymer that has a melting point of 90 to 140°C and is obtained by polymerizing ethylene and/or an α-olefin having 3 to 10 carbon atoms.
(12) The multilayer sheet according to (11), wherein the layer [I] includes a hindered amine light stabilizer in an amount of 0.1 to 5 parts by weight based on 100 parts by weight of the alkoxysilyl group-containing hydrogenated block copolymer (i), and/or the layer [II] includes a hindered amine light stabilizer in an amount of 0.1 to 5 parts by weight based on 100 parts by weight of the (co)polymer (ii). [0021]
(13) The multilayer sheet according to (II), wherein the layer [I] includes a UV absorber in an amount of 0.01 to 0.2 parts by weight based on 100 parts by weight of the alkoxysilyl group-containing hydrogenated block copolymer (i), and/or the layer [II] includes a UV absorber in an amount of 0.01 to 0.2 parts by weight based on 100 parts by weight of the (co)polymer (ii).
(14) The multilayer sheet according to (11), the multilayer sheet having a layer configuration that includes the layer [I] and the layer [II], or a layer configuration that sequentially includes the layer [I], the layer [II], and the layer [I].
(15) A method for encapsulating a solar cell element including disposing the multilayer sheet according to (14) so that the layer [I] of the multilayer sheet comes in contact with a crystalline solar cell.

### ADVANTAGEOUS EFFECTS OF THE INVENTION

Since the alkoxysilyl group-containing hydrogenated block copolymer according to one aspect of the invention includes the polymer block [A] that has a high glass transition temperature and exhibits excellent heat resistance, and the polymer block [B] that has a low glass transition temperature and exhibits excellent flexibility, the alkoxysilyl group-containing hydrogenated block copolymer exhibits low hygroscopicity, a low water vapor permeability, transparency, weatherability, and flexibility.

Since the alkoxysilyl group-containing hydrogenated block copolymer includes an alkoxysilyl group, the solar cell element encapsulating material that includes the alkoxysilyl group-containing hydrogenated block copolymer maintains excellent adhesion to glass even when exposed to a high-temperature/high-humidity environment for a long time, and can encapsulate a solar cell element without applying a special waterproof treatment.

The alkoxysilyl group-containing hydrogenated block copolymer according to one aspect of the invention can be efficiently and easily produced by the method according to one aspect of the invention.

The solar cell element encapsulating material, the sheet that includes the solar cell element encapsulating material, the laminated sheet, and the multilayer sheet according to the aspects of the invention exhibit low hygroscopicity, a low water vapor permeability, transparency, weatherability, flexibility, heat resistance, and a low-temperature encapsulating capability, maintain excellent adhesion to glass even when exposed to a high-temperature/high-humidity environment for a long time, and can encapsulate a solar cell element without applying a special waterproof treatment.

Since the solar cell element encapsulating material, the sheet, the laminated sheet, and the multilayer sheet exhibit sufficient heat resistance even if the solar cell element encapsulating material, the sheet, the laminated sheet, and the multilayer sheet are not crosslinked and cured using a crosslinking agent (e.g., organic peroxide), a crosslinking step can be omitted from the solar cell production process.

Since the multilayer sheet according to one aspect of the invention exhibits improved flexibility, it is possible to prevent breakage (cracking) of a solar cell element (particularly a crystalline solar cell element) during a vacuum lamination process.

The method for encapsulating a solar cell element according to one aspect of the invention makes it possible to encapsulate a solar cell element without applying a special waterproof treatment.

### BRIEF DESCRIPTION OF DRAWINGS

FIG. 1 is a cross-sectional view schematically illustrating a crystalline silicon solar cell module.

### DESCRIPTION OF EMBODIMENTS

An alkoxysilyl group-containing hydrogenated block copolymer, a method for producing an alkoxysilyl group-containing hydrogenated block copolymer, a solar cell element encapsulating material, a sheet, a laminated sheet, a multilayer sheet, and a method for encapsulating a solar cell element according to several embodiments of the invention are described below.

### 1) Alkoxysilyl group-containing hydrogenated block copolymer

An alkoxysilyl group-containing hydrogenated block copolymer according to one embodiment of the invention is a hydrogenated block copolymer that is produced by hydrogenating 90% or more of carbon-carbon unsaturated bonds of a block copolymer that includes at least two polymer blocks [A] and at least one polymer block [B], and includes an alkoxysilyl group, the polymer block [A] including a repeating unit derived from an aromatic vinyl compound as the main component, and the polymer block [B] including a repeating unit derived from a linear conjugated diene compound as the main component.

### (1) Block copolymer

The block copolymer used in connection with the invention includes at least two polymer blocks [A] and at least one polymer block [B].

The polymer block [A] includes a repeating unit derived from an aromatic vinyl compound as the main component. The content of the repeating unit derived from the aromatic vinyl compound in the polymer block [A] is normally 90 wt% or more, preferably 95 wt% or more, and more preferably 99 wt% or more.

Examples of a component other than the repeating unit derived from the aromatic vinyl compound that may be included in the polymer block [A] include a repeating unit derived from a linear conjugated diene and a repeating unit derived from an additional unsaturated compound (described later). The content of the component other than the repeating unit derived from the aromatic vinyl compound in the polymer block [A] is normally 10 wt% or less, preferably 5 wt% or less, and more preferably 1 wt% or less. If the content of the repeating unit derived from the aromatic vinyl compound in the polymer block [A] is too low, the resulting polymer may exhibit low heat resistance.

Specific examples of the aromatic vinyl compound include styrene, α-methylstyrene, 2-methylstyrene, 3-methylstyrene, 4-methylstyrene, 2,4-diisopropylstyrene, 2,4-dimethylstyrene, 4-t-butylstyrene, 5-t-butyl-2-methylstyrene, 4-chlorostyrene, 3,4-dichlorostyrene, 4-fluorostyrene, 4-methoxystyrene, 4-phenylstyrene, and the like. Among these, aromatic vinyl compounds that do not include a polar group (e.g., hydroxyl group, alkoxy group, and halogen atom) are preferable from the viewpoint of hygroscopicity, and styrene is particularly preferable.

Examples of the additional unsaturated compound include linear vinyl compounds, cyclic vinyl compounds, unsaturated cyclic acid anhydrides, unsaturated imide compounds, and the like. These unsaturated compounds may be substituted with an alkyl group, a nitrile group, an alkoxy group, an alkoxycarbonyl group, a carboxyl group, or a halogen atom. It is preferable that these unsaturated compounds do not include a polar group (e.g., nitrile group, alkoxy group, alkoxycarbonyl group, carboxyl group, and halogen atom) from the viewpoint of hygroscopicity.

Examples of the linear vinyl compounds include ethylene, propylene, 1-butene, 1-pentene, 1-hexene, 1-heptene, 1-octene, 1-nonene, 1-decene, 1-dodecene, 1-eicosene, 4-methyl-1-pentene, 4,6-dimethyl-1-heptene, and the like. Examples of the cyclic vinyl compounds include vinylcyclohexane and the like. Among these, linear olefins are preferable, and ethylene and propylene are more preferable.

The number of the polymer blocks [A] in the block copolymer is normally 2 to 5, preferably 2 to 4, and more preferably 2 or 3. The plurality of polymer blocks [A] may be either identical or different.

The polymer block [B] includes a repeating unit derived from a linear conjugated diene compound as the main component.

The content of the repeating unit derived from the linear conjugated diene compound in the polymer block [B] is normally 90 wt% or more, preferably 95 wt% or more, and more preferably 99 wt% or more. When the content of the repeating unit derived from the linear conjugated diene compound is within the above range, the resin composition exhibits excellent flexibility and a solar cell element encapsulating capability in a well-balanced manner.

Examples of a component other than the repeating unit derived from the linear conjugated diene compound that may be included in the polymer block [B] include a repeating unit derived from the aromatic vinyl compound and a repeating unit derived from the additional unsaturated compound. The content of the component other than the repeating unit derived from the linear conjugated diene compound in the polymer block [B] is normally 10 wt% or less, preferably 5 wt% or less, and more preferably 1 wt% or less. If the content of the repeating unit derived from the aromatic vinyl compound in the polymer block [B] is too high, the flexibility and the solar cell element encapsulating capability of the resin composition may deteriorate.

When the block copolymer includes a plurality of polymer blocks [B], the plurality of polymer blocks [B] may be either identical or different.

Specific examples of the linear conjugated diene compound include 1,3-butadiene, isoprene, 2,3-dimethyl-1,3-butadiene, 1,3-pentadiene, and the like. It is preferable that the linear conjugated diene compound does not include a polar group (e.g., hydroxyl group, alkoxy group, halogen atom, and carboxyl group) from the viewpoint of hygroscopicity. 1,3-Butadiene and isoprene are particularly preferable as the linear conjugated diene compound.

When the block copolymer includes a plurality of polymer blocks [A] and a plurality of polymer blocks [B], the ratio (Mw(A1)/Mw(A2)) of the highest weight average molecular weight Mw(A1) to the lowest weight average molecular weight Mw(A2) among the weight average molecular weights of the plurality of polymer blocks [A], and the ratio (Mw(B1)/Mw(B2)) of the highest weight average molecular weight Mw(B1) to the lowest weight average molecular weight Mw(B2) among the weight average molecular weights of the plurality of polymer blocks [B] are 2.0 or less, preferably 1.5 or less, and more preferably 1.2 or less.

The block copolymer may be a chain block copolymer or a radial block copolymer. It is preferable that the block copolymer be a chain block copolymer since the block copolymer exhibits excellent mechanical strength.

It is most preferable that the block copolymer be a triblock copolymer ([A]/[B]/[A]) in which the polymer block [A] is bonded to each end of the polymer block [B], or a pentablock copolymer([A]/[B]/[A]/[B]/[A]) in which the polymer block [B] is bonded to each end of the polymer block [A], and the polymer block [A] is bonded to the other end of each polymer block [B].

The ratio (wA:wB) of the weight fraction wA of the polymer block [A] in the block copolymer to the weight fraction wB of the polymer block [B] in the block copolymer is 20:80 to 60:40, preferably 25:75 to 60:40, and more preferably 40:60 to 60:40. If the weight fraction wA is too high, the resulting solar cell element encapsulating material may exhibit high heat resistance, but may exhibit low flexibility and a poor encapsulating capability. If the weight fraction wA is too low, the resulting solar cell element encapsulating material may exhibit poor heat resistance.

The polystyrene-reduced weight average molecular weight (Mw) of the block copolymer measured by gel permeation chromatography (GPC) using tetrahydrofuran (THF) as an eluant is normally 30,000 to 200,000, preferably 40,000 to 150,000, and more preferably 50,000 to 100,000. The molecular weight distribution (Mw/Mn) of the block copolymer is preferably 3 or less, more preferably 2 or less, and particularly preferably 1.5 or less.

When producing a block copolymer ([A]/[B]/[A]) that includes three polymer blocks, for example, the block copolymer may be produced by a method that includes a first step that polymerizes a monomer mixture (a1) that includes the aromatic vinyl compound that produces the polymer block [A], a second step that polymerizes a monomer mixture (b1) that includes the linear conjugated diene compound that produces the polymer block [B], and a third step that polymerizes a monomer mixture (a2) that includes the aromatic vinyl compound that produces the polymer block [A] (the monomer mixture (a1) and the monomer mixture (a2) may be either identical or different), a method that includes a first step that polymerizes a monomer mixture (a1) that produces the polymer block [A], a second step that polymerizes a monomer mixture (b1) that produces the polymer block [B], and a third step that couples the ends of the resulting polymer block [B] using a coupling agent, or the like.

The monomer mixture may be polymerized by radical polymerization, anionic polymerization, cationic polymerization, coordination anionic polymerization, coordination cationic polymerization, or the like. It is preferable to implement radical polymerization, anionic polymerization, cationic polymerization, or the like by living polymerization (particularly living anionic polymerization) since the polymerization operation and the hydrogenation reaction in the subsequent step are facilitated, and the transparency of the resulting block copolymer is improved.

The monomer mixture is polymerized in the presence of an initiator. Examples of the initiator that may be used for living anionic polymerization include monoorganolithium compounds such as n-butyllithium, sec-butyllithium, t-butyllithium, hexyllithium, and phenyllithium; polyfunctional organolithium compounds such as dilithiomethane, 1,4-dilithiobutane, and 1,4-dilithio-2-ethylcyclohexane; and the like.

The reaction temperature is normally 0 to 100°C, preferably 10 to 80°C, and particularly preferably 20 to 70°C.

The monomer mixture may be polymerized by solution polymerization, slurry polymerization, or the like. Note that it is possible to easily remove heat of reaction when using solution polymerization. In this case, an inert solvent that dissolves the polymer obtained in each step is used.

The solvent is not particularly limited as long as the solvent is inert to the reaction. Examples of the solvent include aliphatic hydrocarbons such as n-butane, n-pentane, isopentane, n-hexane, n-heptane, and isooctane; alicyclic hydrocarbons such as cyclopentane, cyclohexane, methylcyclopentane, methylcyclohexane, decalin, bicyclo[4,3.0]nonane, and tricyclo[4.3.0.1^{2,5}]decane; aromatic hydrocarbons such as benzene and toluene; and the like. It is preferable to use an alicyclic hydrocarbon since an alicyclic hydrocarbon can be directly used as an inert solvent for the subsequent hydrogenation reaction, and can easily dissolve the block copolymer. These solvents may be used either alone or in combination.

The solvent is normally used in an amount of 200 to 2000 parts by weight based on 100 parts by weight of the monomers in total.

When the monomer mixture includes two or more components, a randomizer or the like may be used in order to prevent a situation in which only one component forms a long chain. It is preferable to use a Lewis base compound or the like as the randomizer when implementing the polymerization reaction by anionic polymerization.

Examples of the Lewis base compound include ether compounds such as dimethyl ether, diethyl ether, diisopropyl ether, dibutyl ether, tetrahydrafuran, diphenyl ether, ethylene glycol diethyl ether, and ethylene glycol methyl phenyl ether; tertiary amine compounds such as tetramethylethylenediamine, trimethylamine, triethylamine, and pyridine; alkali metal alkoxide compounds such as potassium t-amyloxide and potassium t-butoxide; phosphine compounds such as triphenylphosphine; and the like. These Lewis base compounds may be used either alone or in combination.

### (2) Hydrogenated block copolymer

The hydrogenated block copolymer used in connection with the invention is obtained by hydrogenating the carbon-carbon unsaturated bonds of the main chain, the side chain, and the aromatic ring of the block copolymer. The hydrogenation rate of the hydrogenated block copolymer is normally 90% or more, preferably 97% or more, and more preferably 99% or more. The resulting solar cell element encapsulating material exhibits improved transparency, weatherability, and heat resistance as the hydrogenation rate of the hydrogenated block copolymer increases. The hydrogenation rate of the hydrogenated block copolymer may be determined by ¹H-NMR analysis.

The hydrogenation rate of the carbon-carbon unsaturated bonds of the main chain and the side chain is preferably 95% or more, and more preferably 99% or more. The light resistance and the oxidation resistance of the solar cell element encapsulating material are improved by increasing the hydrogenation rate of the carbon-carbon unsaturated bonds of the main chain and the side chain.

The hydrogenation rate of the carbon-carbon unsaturated bonds of the aromatic ring is preferably 90% or more, more preferably 93% or more, and particularly preferably 95% or more. The glass transition temperature of the polymer block [A] increases as a result of increasing the hydrogenation rate of the carbon-carbon unsaturated bonds of the aromatic ring, so that the solar cell element encapsulating material exhibits sufficient heat resistance even if the solar cell element encapsulating material is not crosslinked.

The unsaturated bond hydrogenation method, the reaction configuration, and the like are not particularly limited. It is preferable to use a hydrogenation method that can increase the hydrogenation rate, and causes a polymer chain cleavage reaction to only a small extent.

For example, a hydrogenation method that utilizes an organic solvent and a catalyst that includes at least one metal selected from nickel, cobalt, iron, titanium, rhodium, palladium, platinum, ruthenium, rhenium, and the like may be used.

A heterogeneous catalyst or a homogeneous catalyst may be used as the hydrogenation catalyst.

The heterogeneous catalyst may be used directly as a metal or a metal compound, or may be used in a state in which the heterogeneous catalyst is supported on an appropriate carrier. Examples of the carrier include activated carbon, silica, alumina, calcium carbonate, titania, magnesia, zirconia, diatomaceous earth, silicon carbide, calcium fluoride, and the like.

The catalyst is normally supported on the carrier in an amount of 0.1 to 60 wt%, and preferably 1 to 50 wt%, based on the total amount of the catalyst and the carrier. It is preferable use a supported catalyst having a specific surface area of 100 to 500 m²/g and an average pore size of 100 to 1000 angstroms (more preferably 200 to 500 angstroms), for example. Note that the specific surface area refers to a value obtained by measuring the nitrogen adsorption amount, and calculating the specific surface area using the BET equation, and the average pore size refers to a value measured by mercury porosimetry.

A catalyst prepared by combining a nickel, cobalt, titanium, or iron compound with an organometallic compound (e.g., organoaluminum compound or organolithium compound), an organometallic complex catalyst, or the like may be used as the homogeneous catalyst.

An acetylacetonato compound, a carboxylate, a cyclopentadienyl compound, or the like of each metal may be used as the nickel, cobalt, titanium, or iron compound.

Examples of the organoaluminum compound include alkylaluminum compounds such as triethylaluminum and triisobutylaluminum; aluminum halide compounds such as diethylaluminum chloride and ethylaluminum dichloride; hydrogenated alkylaluminum compounds such as diisobutylaluminum hydride; and the like.

Examples of the organometallic complex catalyst include dihydridotetrakis(triphenylphosphine)ruthenium, dihydridotetrakis(triphenylphosphine)iron, bis(cyclooctadiene)nickel, bis(cyclopentadienyl)nickel, and the like.

These hydrogenation catalysts may be used either alone or in combination. The hydrogenation catalyst is normally used in an amount of 0.01 to 100 parts by weight, preferably 0.05 to 50 parts by weight, and more preferably 0.1 to 30 parts by weight, based on 100 parts by weight of the polymer.

The hydrogenation temperature is normally 10 to 250°C, preferably 50 to 200°C, and more preferably 80 to 180°C. When the hydrogenation temperature is within the above range, the hydrogenation rate increases, and cleavage of the molecule decreases.

The hydrogen pressure is normally 0.1 to 30 MPa, preferably 1 to 20 MPa, and more preferably 2 to 10 MPa. When the hydrogen pressure is within the above range, the hydrogenation rate increases, cleavage of the molecule decreases, and excellent operability (handling capability) is achieved.

After completion of the reaction, the hydrogenation catalyst and/or the polymerization catalyst are/is removed from the reaction solution by filtration, centrifugation, or the like, and the hydrogenated block copolymer is collected. The hydrogenated block copolymer may be collected from the reaction solution by a steam coagulation method that removes the solvent from the solution of the hydrogenated block copolymer by steam stripping, a direct solvent removal method that removes the solvent with heating under reduced pressure, a coagulation method wherein the solution is poured into a poor solvent to effect precipitation and coagulation of the hydrogenated block copolymer, or the like.

The hydrogenated block copolymer thus collected may have an arbitrary shape (form). The hydrogenated block copolymer is normally pelletized so that the hydrogenated block copolymer can be easily subjected to the subsequent silylation modification reaction (i.e., a reaction that introduces an alkoxysilyl group). When using the direct solvent removal method, the melted hydrogenated block copolymer may be extruded from a die in the shape of a strand, cooled, and cut into pellets using a pelletizer, and then molded (formed), for example. When using the coagulation method, the resulting coagulate may be dried, extruded in a melted state using an extruder, cut into pellets using a pelletizer, and then subjected to the silylation modification reaction, for example.

The polystyrene-reduced weight average molecular weight (Mw) of the hydrogenated block copolymer measured by gel permeation chromatography (GPC) using THF as an eluant is normally 30,000 to 200,000, preferably 40,000 to 150,000, and more preferably 50,000 to 100,000. When the Mw of the hydrogenated block copolymer is within the above range, the mechanical strength and the heat resistance of the resulting solar cell element encapsulating material are improved.

The molecular weight distribution (Mw/Mn) of the hydrogenated block copolymer is preferably 3 or less, more preferably 2 or less, and particularly preferably 1.5 or less. When the Mw and the molecular weight distribution (Mw/Mn) of the hydrogenated block copolymer are within the above ranges, the mechanical strength and the heat resistance of the resulting solar cell element encapsulating material are improved.

### (3) Alkoxysilyl group-containing hydrogenated block copolymer

The alkoxysilyl group-containing hydrogenated block copolymer according to one embodiment of the invention is obtained by introducing an alkoxysilyl group into the hydrogenated block copolymer. The alkoxysilyl group may be bonded directly to the hydrogenated block copolymer, or may be bonded to the hydrogenated block copolymer via a divalent organic group (e.g., alkylene group).

The alkoxysilyl group is normally introduced into the hydrogenated block copolymer in an amount of 0.1 to 10 g/100 g, preferably 0.2 to 5 g/100 g, and more preferably 0.3 to 3 g/100 g. If the alkoxysilyl group is introduced into the hydrogenated block copolymer in too large an amount, alkoxysilyl groups that decompose due to a small amount of water or the like may be crosslinked to a large extent, so that adhesion to glass may decrease.

The alkoxysilyl group introduction amount may be calculated from the ¹H-NMR spectrum data. Note that the number of integrations may be increased when the alkoxysilyl group introduction amount is small.

The alkoxysilyl group may be introduced into the hydrogenated block copolymer using an arbitrary method. It is preferable to react the hydrogenated block copolymer and an ethylenically unsaturated silane compound in the presence of an organic peroxide (as described later).

### 2) Method for producing alkoxysilyl group-containing hydrogenated block copolymer

A method for producing an alkoxysilyl group-containing hydrogenated block copolymer according to one embodiment of the invention includes reacting an ethylenically unsaturated silane compound with the hydrogenated block copolymer in the presence of an organic peroxide.

The ethylenically unsaturated silane compound is not particularly limited as long as the ethylenically unsaturated silane compound undergoes graft polymerization with the hydrogenated block copolymer in the presence of an organic peroxide, so that the alkoxysilyl group can be introduced into the hydrogenated block copolymer. Examples of the ethylenically unsaturated silane compound include vinyl group-containing alkoxysilanes such as vinyltrimethoxysilane, vinyltriethoxysilane, dimethoxymethylvinylsilane, and diethoxymethylvinylsilane; allyl group-containing alkoxysilanes such as allyltrimethoxysilane and allyltriethoxysilane; p-styryl group-containing alkoxysilanes such as p-styryltrimethoxysilane and p-styryltriethoxysilane; 3-methacryloxypropyl group-containing alkoxysilanes such as 3-methacryloxypropyltrimethoxysilane, 3-methacryloxypropylmethyldimethoxysilane, 3-methacryloxypropyltriethoxysilane, and 3-methacryloxypropylmethyldiethoxysilane; 3-acryloxypropyl group-containing alkoxysilanes such as 3-acryloxyprophyltrimethoxysilane and 3-acryloxyprophyltriethoxysilane; 2-norbornen-5-yl group-containing alkoxysilanes such as 2-norbornen-5-yltrimethoxysilane; and the like.

Among these, vinyltrimethoxysilane, vinyltriethoxysilane, dimethoxymethylvinylsilane, diethoxymethylvinylsilane, allyltrimethoxysilane, allyltriethoxysilane, and p-styryltrimethoxysilane are preferable since the advantageous effects of the invention can be more easily achieved.

These ethylenically unsaturated silane compounds may be used either alone or in combination.

The ethylenically unsaturated silane compound is normally used in an amount of 0.1 to 10 parts by weight, preferably 0.2 to 5 parts by weight, and more preferably 0.3 to 3 parts by weight, based on 100 parts by weight of the hydrogenated block copolymer.

The organic peroxide is not particularly limited as long as the organic peroxide functions as a radical reaction initiator. Examples of the organic peroxide include dibenzoyl peroxide, t-butyl peroxyacetate, 2,2-di-(t-butylperoxy)butane, t-butyl peroxybenzoate, t-butylcumyl peroxide, dicumyl peroxide, di-t-hexyl peroxide, 2,5-dimethyl-2,5-di(t-butylperoxy)hexane, di-t-butyl peroxide, 2,5-dimethyl-2,5-di(t-butylperoxy)hexane-3, t-butyl hydroperoxide, t-buthyl peroxyisobutyrate, lauroyl peroxide, dipropionyl peroxide, p-menthane hydroperoxide, and the like. These organic peroxides may be used either alone or in combination.

It is preferable to use a compound having a one-minute half-life temperature of 170 to 190°C as the organic peroxide. For example, t-butylcumyl peroxide, dicumyl peroxide, di-t-hexyl peroxide, 2,5-dimethyl-2,5-di(t-butylperoxy)hexane, di-t-butyl peroxide, and the like are preferably used.

The organic peroxide is normally used in an amount of 0.01 to 5 parts by weight, preferably 0.2 to 3 parts by weight, and more preferably 0.3 to 2 parts by weight, based on 100 parts by weight of the hydrogenated block copolymer.

A heating kneader or a reactor may be used when reacting the hydrogenated block copolymer and the ethylenically unsaturated silane compound in the presence of the organic peroxide. For example, a mixture of the hydrogenated block copolymer, the ethylenically unsaturated silane compound, and the organic peroxide may be heated and melted at a temperature equal to or higher than the melting point of the block copolymer using a twin-screw kneader, and kneaded for a desired time to obtain the target product.

The kneading temperature is normally 180 to 240°C, preferably 190 to 230°C, and more preferably 200 to 220°C.

The heating/kneading time is normally 0.1 to 15 minutes, preferably 0.2 to 10 minutes, and more preferably 0.3 to 5 minutes. When using continuous kneading equipment such as a twin-screw kneader or a single-screw extruder, the mixture may be continuously kneaded and extruded so that the residence time is within the above range.

The molecular weight of the resulting alkoxysilyl group-containing hydrogenated block copolymer is substantially identical with that of the hydrogenated block copolymer used as the raw material since only a small amount of alkoxysilyl groups are introduced into the hydrogenated block copolymer. However, since the alkoxysilyl group-containing hydrogenated block copolymer is obtained by the modification reaction in the presence of the organic peroxide, the polymer also undergoes a crosslinking reaction and a cleavage reaction, so that the molecular weight distribution of the hydrogenated block copolymer increases. The polystyrene-reduced weight average molecular weight (Mw) of the alkoxysilyl group-containing hydrogenated block copolymer measured by GPC using THF as an eluant is normally 30,000 to 200,000, preferably 40,000 to 150,000, and more preferably 50,000 to 120,000, and the molecular weight distribution (Mw/Mn) of the alkoxysilyl group-containing hydrogenated block copolymer is normally 3.5 or less, preferably 2.5 or less, and particularly preferably 2.0 or less. When the Mw and the molecular weight distribution (Mw/Mn) of the alkoxysilyl group-containing hydrogenated block copolymer are within the above ranges, the resulting solar cell element encapsulating material maintains excellent mechanical strength and tensile elongation.

Since the alkoxysilyl group-containing hydrogenated block copolymer exhibits excellent adhesion to glass, a metal, and the like, the surface of a solar cell element encapsulating material produced using the alkoxysilyl group-containing hydrogenated block copolymer exhibits excellent adhesion to a glass substrate, a copper wire, and the like. Therefore, the solar cell element encapsulating material can maintain sufficient adhesion even when exposed to a high-temperature/high-humidity environment at 85°C and 85%RH for 1000 hours (i.e., normal solar cell reliability evaluation conditions).

### 3) Solar cell element encapsulating material

A solar cell element encapsulating material according to one embodiment of the invention includes the alkoxysilyl group-containing hydrogenated block copolymer (hereinafter may be referred to as "alkoxysilylated polymer") according to one embodiment of the invention.

The content of the alkoxysilylated polymer according to one embodiment of the invention in the solar cell element encapsulating material according to one embodiment of the invention is normally 60 wt% or more, preferably 75 wt% or more, and more preferably 90 wt% or more. It is preferable that the solar cell element encapsulating material include an additive for improving the performance of the solar cell element encapsulating material in addition to the alkoxysilylated polymer.

Examples of the additive include a polymer other than the alkoxysilylated polymer, a light stabilizer, a UV absorber, an antioxidant, a lubricant, an inorganic filler, and the like.

These additives may be used either alone or in combination.

### Polymer other than alkoxysilylated polymer

The polymer other than the alkoxysilylated polymer (hereinafter may be referred to as "additional polymer") is added to improve the resin properties of the solar cell element encapsulating material. Examples of the additional polymer include hydrogenated block copolymers as a precursor of the alkoxysilylated polymer; olefin polymers such as an ethylene-propylene copolymer and a propylene-ethylene-1-butene copolymer; isobutylene polymers such as polyisobutylene and a hydrogenated isobutylene-isoprene copolymer; diene polymers such as an acrylonitrile-butadiene random copolymer, an acrylonitrile-butadiene-styrene copolymer, and an isoprene-styrene block copolymer; acrylic polymers such as polybutyl acrylate and polyhydroxyethyl methacrylate; epoxy-based polymers such as polyethylene oxide, polypropylene oxide, and epichlorohydrin rubber; petroleum resins such as a 1,3-pentadiene-based petroleum resin, a cyclopentadiene-based petroleum resin, and an aromatic petroleum resin, and hydrogenated products thereof; and the like.

### Light stabilizer

The light stabilizer is added to improve the weatherability of the solar cell element encapsulating material. A hindered amine light stabilizer is preferable as the light stabilizer, Examples of the hindered amine light stabilizer include compounds that include a 3,5-di-t-butyl-4-hydroxyphenyl group in the structure, compounds that include a 2,2,6,6-tetramethylpiperidyl group in the structure, compounds that include a 1,2,2,6,6-pentamethyl-4-piperidyl group the structure, and the like.

Specific examples of the hindered amine light stabilizer include a mixed ester of 1,2,3,4-butanetetracarboxylic, acid, 1,2,2,6,6-pentamethyl-4-piperidinol, and 3,9-bis(2-hydroxy-1,1-dimethylethyl)-2,4,8,10-tetraoxaspiro[5,5]undecane, a polycondensate of 1,6-hexanediamine-N,N'-bis(2,2,6,6-tetramethyl-4-piperidyl) and morpholine-2,4,6-trichloro-1,3,5-triazine, 1-[2-[3-(3,5-di-t-butyl-4-hydroxyphenyl)propionyloxy]ethyl]-4-[3-(3,5-di-t-butyl-4-hydroxyphenyl)propionyloxy]-2,2,6,6-tetramethylpiperidine, bis(1,2,2,6,6-pentamethyl-4-piperidyl) 2-(3,5-di-t-butyl-4-hydroxybenzyl)-2-n-butylmalonate, bis(1,2,2,6,6-pentamethyl-4-piperidyl) 2-(3,5-di-t-butyl-4-hydroxybenzyl)-2-n-butylmalonate, 4-[3-(3,5-di-t-butyl-4-hydroxyphenyl)propionyloxy]-1-[2-[3-(3,5-di-t-butyl-4-hydroxyphenyl)propionyloxy]ethyl]-2,2,6,6-tetramethylpiperidine, 4-[N-(1-benzyl-2-phenylethyl)-N-formylamino]-2,2,6,6-tetramethylpiperidine, 4-[N-[2-(1-pyrrolidyl)ethyl)-N-formylamino]]-2,2,6,6-tetramethylpiperidine, 4-[N-[2-(4-morpholinyl)ethyl]-N-fomylamino]-2,2,6,6-tetramethyl-N-methylpiperidine, 4-[N-[2-(4-morpholinyl)ethyl]-N-formylamino]-2,2,6,6-tetramethylpiperidine, 4-[N-[2-(diisopropylamino)ethyl]-N-formylamino]-2,2,6,6-tetramethylpiperidine, 4-[N-(2,4,6-trimethylbenzyl)-N-formylamino]-2,2,6,6-tetramethylpiperidine, 4-[N-[3-(2-ethylhexaoxy)propyl]-N-formylamino]-2,2,6,6-tetramethylpiperidine, 4-[N-(3,4-methylenedioxy)benzyl]-N-formylamino-2,2,6,6-tetramethylpiperidine, 4-[N-(bicyclo[2.2.1]heptyl)-N-formylamino]-2,2,6,6-tetramethylpiperidine, 4-(N-1,2,2-trimethylpropyl-N-formylamino)-2,2,6,6-tetramethylpiperidine, 4-(N-1,3-dimethylbutyl-N-formylamino)-2,2,6,6-tetramethylpiperidine, 4-[N-(1-benzylethyl)-N-formylamino]-2,2,6,6-tetramethylpiperidine, 4-[N-(2,2-dimethylpropyl)-N-formylamino]-2,2,6,6-tetramethylpiperidine, 4-[N-(2-ethylhexyl)-N-formylamino]-2,2,6,6-tetramethylpiperidine, 4-[N-(3-methylbutyl)-N-formylamino]-2,2,6,6-tetramethylpiperidine, 4-[N-(4-hydroxybutyl)-N-formylamino]-2,2,6,6-tetramethylpiperidine, 4-[N-(4-hydroxybutyl)-N-formylamino]-2,2,6,6-tetramethylpiperidine, 4-(N-isopropyl-N-formylamino)-2,2,6,6-tetramethylpiperidine, 4-(N-isopropyl-N-formylamino)-2,2,6,6-tetramethylpiperidine, 4-(N-t-butyl-N-formylamino)-2,2,6,6-tetramethylpiperidine, 4-(N-isopropylbenzyl-N-formylamino)-2,2,6,6-tetramethylpiperidine, 4-(N-ethoxyethyl-N-formylamino)-2,2,6,6-tetramethylpiperidine, 4-(N-ethoxypropyl-N-formylamino)-2,2,6,6-tetramethylpiperidine, 4-(N-octadecyl-N-formylamino)-2,2,6,6-tetramethylpiperidine, 4-(N-octyl-N-formylamino)-2,2,6,6-tetramethyl-N-methylpiperidine, 4-(N-octyl-N-formylamino)-2,2,6,6-tetramethylpiperidine, 4-(N-chlorobenzyl-N-formylamino)-2,2,6,6-tetramethylpiperidine, 4-[N-(2-diethylaminoethyl)-N-formylamino]-2,2,6,6-tetramethylpiperidine, 4-(N-cyclododecyl-N-formylamino)-2,2,6,6-tetramethylpiperidine, 4-(N-cyclohexyl-N-formylamino)-2,2,6,6-tetramethyl-N-methylcarbonylpiperidine, 4-(N-cyclohexyl-N-formylamino)-2,2,6,6-tetramethyl-N-methylpyridine, 4-(N-cyclohexyl-N-formylamino)-2,2,6,6-tetramethylpyridine, 4-(N-cyclopentyl-N-formylamino)-2,2,6,6-tetramethyl-N-methylpiperidine, 4-(N-cyclopentyl-N-formylamino)-2,2,6,6-tetramethylpiperidine, 4-[N-(3-dimethylaminopropyl)-N-formylamino]-2,2,6,6-tetramethylpiperidine, 4-(N-decyl-N-formylamino)-2,2,6,6-tetramethyl-N-methylpiperidine, 4-(N-decyl-N-formylamino)-2,2,6,6-tetramethylpiperidine, 4-(N-dodecyl-N-formylamino)-2,2,6,6-tetramethylpiperidine, 4-(N-pyridinylmethyl-N-formylamino)-2,2,6,6-tetramethylpiperidine, 4-(N-phenylethyl-N-formylamino)-2,2,6,6-tetramethyl-N-methylpyridine, 4-(N-phenylethyl-N-formylamino)-2,2,6,6-tetramethylpyridine, 4-(N-butyl-N-formylamino)-2,2,6,6-tetramethyl-N-methylpiperidine, 4-(N-butyl-N-formylamino)-2,2,6,6-tetramethyl-N-methylpiperidine, 4-(N-fluorobenzyl-N-formylamino)-2,2,6,6-tetramethylpiperidine, 4-(N-hexyl-N-formylamino)-2,2,6,6-tetramethyl-N-methylpiperidine, 4-(N-hexyl-N-formylamino)-2,2,6,6-tetramethylpiperidine, 4-(N-pentyl-N-formylamino)-2,2,6,6-tetramethyl-N-methylpiperidine, 4-(N-pentyl-N-formylamino)-2,2,6,6-tetramethylpiperidine, 4-(N-methylcyclohexyl-N-formylamino)-2,2,6,6-tetramethylpyridine, 4-(N-methylbenzyl-N-formylamino)-2,2,6,6-tetramethylpiperidine, 4-(N-methoxybenzyl-N-formylamino)-2,2,6,6-tetramethylpiperidine, 4-(formylamino)-2,2,6,6-tetramethyl-N-methylpiperidine, 4-(formylamino)-2,2,6,6-tetramethylpiperidine, 4-[N-(2,2,6,6-tetramethyl-4-piperidyl)-N-formylamino]-2,2,6,6-tetramethyl-N-methylpyridine, 4-[N-(2,2,6,6-tetramethyl-4-piperidyl)-N-formylamino]-2,2,6,6-tetramethylpyridine, N,N',N",N"'-tetrakis[4,6-bis[butyl-(N-methyl-2,2,6,6-tetramethylpiperidin-4-yl)amino]-triazin-2-yl]-4,7-diazadecane-1,10-amine, N,N'-bis(2,2,6,6-tetramethyl-4-N-methylpiperidyl)-N,N'-diformyl-1,4-xylylenediamine, N,N'-bis(2,2,6,6-tetramethyl-4-N-methylpiperidyl)-N,N'-diformyl-trimethylenediamine, N,N'-bis(2,2,6,6-tetramethyl-4-N-methylpiperidyl)-N,N'-diformyl-hexamethylenediamine, N,N'-bis(2,2,6,6-tetramethyl-4-N-methylpiperidyl)-N,N'-diformyl-ethylenediamine, N,N'-bis(2,2,6,6-tetramethyl-4-piperidyl)-N,N'-diformyl-1,4-xylylenediamine, N,N'-bis(2,2,6,6-tetramethyl-4-piperidyl)-N,N'-diformylethylenediamine, N,N'-bis(2,2,6,6-tetramethyl-4-piperidyl)-N,N'-diformyl-trimethylenediamine, N,N'-bis(2,2,6,6-tetramethyl-4-piperidyl)-N,N'-diformylhexamethylenediamine, N,N'-bis(2,2,6,6-tetramethyl-4-piperidyl)-N,N'-bishexamethyleneacrylic acid amide, N,N'-bis(2,2,6,6-tetramethyl-4-piperidyl)-N,N'-bishexamethylenearachic acid amide, N,N'-bis(2,2,6,6-tetramethyl-4-piperidyl)-N,N'-bishexamethyleneangelic acid amide, N,N'-bis(2,2,6,6-tetramethyl-4-piperidyl)-N,N'-bishexamethyleneundecylic acid amide, N,N'-bis(2,2,6,6-tetramethyl-4-piperidyl)-N,N'-bishexamethyleneundecylenic acid amide, N,N'-bis(2,2,6,6-tetramethyl-4-piperidyl)-NN'-bishexamethyleneoleic acid amide, N,N'-bis(2,2,6,6-tetramethyl-4-piperidyl)-N,N'-bishexamethylenegadoleic acid amide, N,N'-bis(2,2,6,6-tetramethyl-4-piperidyl)-N,N'-bishexamethylenecaprylic acid amide, N,N'-bis(2,2,6,6-tetramethyl-4-piperidyl)-N,N'-bishexamethylenecapric acid amide, N,N'-bis(2,2,6,6-tetramethyl-4-piperidyl)-N,N'-bishexamethylenecaproic acid amide, N,N'-bis(2,2,6,6-tetramethyl-4-piperidyl)-N,N'-bishexamethylenecaprotonic acid amide, N,N'-bis(2,2,6,6-tetramethyl-4-piperidyl)-N,N'-bishexamethylenecitronellic acid amide, N,N'-bis(2,2,6,6-tetramethyl-4-piperidyl)-N,N'-bishexamethylenestearic acid amide, N,N'-bis(2,2,6,6-tetramethyl-4-piperidyl)-N,N'-bishexamethylenezoomaric acid amide, N,N'-bis(2,2,6,6-tetramethyl-4-piperidyl)-N,N'-bishexamethylenetridecylic acid amide, N,N'-bis(2,2,6,6-tetramethyl-4-piperidyl)-N,N'-bishexamethylenenonadecylic acid amide, N,N'-bis(2,2,6,6-tetramethyl-4-piperidyl)-N,N'-bishexamethylenepalmitic acid amide, N,N'-bis(2,2,6,6-tetramethyl-4-piperidyl)-N,N'-bishexamethylenebrenzterebic acid amide, N,N'-bis(2,2,6,6-tetramethyl-4-piperidyl)-N,N'-bishexamethylenepropionic acid amide, N,N'-bis(2,2,6,6-tetramethyl-4-piperidyl)-N,N'-bishexamethyleneheptanoic acid amide, N,N'-bis(2,2,6,6-tetramethyl-4-piperidyl)-N,N'-bishexamethylenebehenic acid amide, N,N'-bis(2,2,6,6-tetramethyl-4-piperidyl)-N,N'-bishexamethyleneargonic acid amide, N,N'-bis(2,2,6,6-tetramethyl-4-piperidyl)-N,N'-bishexamethylenepentadecylic acid amide, N,N'-bis(2,2,6,6-tetramethyl-4-piperidyl)-N,N'-bishexamethylenemargaric acid amide, N,N'-bis(2,2,6,6-tetramethyl-4-piperidyl)-N,N'-bishexamethylenemyristic acid amide, N,N'-bis(2,2,6,6-tetramethyl-4-piperidyl)-N,N'-bishexamethylenelauric acid amide, N,N'-bis(2,2,6,6-tetramethyl-4-piperidyl)-N,N'-bishexamethylenelinderic acid amide, N,N'-bis(2,2,6,6-tetramethyl-4-piperidyl)-N,N'-bishexamethylenevaleric acid amide, N,N'-bis(2,2,6,6-tetramethyl-4-piperidyl)-N,N'-bishexamethyleneacetic acid amide, N,N'-bis(2,2,6,6-tetramethyl-4-piperidyl)-N,N'-bishexamethylene-5-tetradecenoic acid amide, N,N'-bis(2,2,6,6-tetramethyl-4-piperidyl)-N,N'-bishexamethylenebatyric acid amide, a polymer of dimethyl succinate and 4-hydroxy-2,2,6,6-tetramethyl-1-piperidineethanol, a polycondensate of dibutylamine, 1,3,5-triazine, and N,N'-bis(2,2,6,6-tetramethyl-4-piperidyl)butylamine, bis(1,2,2,6,6-pentamethyl-4-piperidyl)-2-(3,5-di-t-butyl-4-hydroxybenzyl)-2-n-butyl malonate, bis(2,2,6,6-tetramethyl-4-piperidyl) sebacate, poly[(6-morpholino-s-triazine-2,4-diyl)[(2,2,6,6-tetramethyl-4-piperidyl)imino]-hexamethylene[(2,2,6,6-tetramethyl-4-piperidyl)imino], poly[[(1,1,3,3-tetramethylbutyl)amino-1,3,5-triazine-2,4-diyl][(2,2,6,6-tetramethyl-4-piperidyl)imino]hexamethylene[(2,2,5,6-tetramethyl-4-piperidyl)imino]], poly[[6-(1,1,3,3-tetramethylbutyl)amino-1,3,5-triazine-2,4-diyl][(2,2,6,6-tetramethyl-4-piperidyl)imino]hexamethylene[(2,2,6,6-tetramethyl-4-piperidyl)imino]], a polymer of N,N'-bis(2,2,6,6-tetramethyl-4-piperidinyl)-1,6-hexanediamine and 2,4,6-trichloro-1,3,5-triazine, a reaction product of n-butyl-1-butaneamine and N-butyl-2,2,6,6-tetramethyl-4-piperidineamine, and the like.

Among these, N,N'-bis(2,2,6,6-tetramethyl-4-N-methylpiperidyl)-N,N'-diformyl-alkylenediamines, N,N'-bis(2,2,6,6-tetramethyl-4-piperidyl)-N,N'-diformylalkylenediamines, N,N'-bis(2,2,6,6-tetramethyl-4-piperidyl)-N,N'-bisalkylenefatty acid amides, and poly[[6-(1,1,3,3-tetramethylbutyl)amino-1,3,5-triazine-2,4-diy][(2,2,6,6-tetramethyl-4-piperidyl)imino]hexamethylene[(2,2,6,6-tetramethyl-4-piperidyl)imino]] are preferable due to excellent weatherability, and N,N'-bis(2,2,6,6-tetramethyl-4-piperidyl)-N,N'-diformylalkylenediamines, a polymer of N,N'-bis(2,2,6,6-tetramethyl-4-piperidinyl)-1,6-hexanediamine and 2,4,6-trichloro-1,3,5-triazine, and a reaction product of n-butyl-1-butaneamine and N-butyl-2,2,6,6-tetramethyl-4-piperidineamine are particularly preferable.

The hindered amine light stabilizer is normally used in an amount of 0.1 to 10 parts by weight, preferably 0.2 to 5 parts by weight, and more preferably 0.4 to 2.5 parts by weight, based on 100 parts by weight of the alkoxysilylated polymer. If the amount of the hindered amine light stabilizer is less than 0.2 parts by weight, the solar cell element encapsulating material may exhibit insufficient weatherability. If the amount of the hindered amine light stabilizer is more than 5 parts by weight, the T-die or the cooling roll of an extruder may be contaminated to a large extent (i.e., workability may deteriorate) during a melt molding process that molds (forms) the solar cell element encapsulating material in the shape of a sheet.

### UV absorber

The UV absorber is added to improve the light stability (light resistance) of the solar cell element encapsulating material. Examples of the UV absorber include a benzophenone UV absorber, a salicylate UV absorber, a benzotriazole UV absorber, and the like. These UV absorbers may be used either alone or in combination.

Examples of the benzophenone UV absorber include 2,4-dihydroxybenzophenone, 2-hydroxy-4-methoxybenzophenone, 2-hydroxy-4-methoxybenzophenone-5-sulfonic acid trihydrate, 2-hydroxy-4-octyloxybenzophenone,4-dodecaoxy-2-hydroxybenzophenone, 4-benzyloxy-2-hydroxybenzophenone, 2,2',4,4'-tetrahydroxybenzophenone, 2,2'-dihydroxy-4,4'-dimethoxybenzophenone, and the like.

Examples of the salicylate UV absorber include phenyl salicylate, 4-t-butylphenyl 2-hydroxybenzoate, phenyl 2-hydroxybenzoate, 2,4-di-t-butylphenyl 3,5-di-t-butyl-4-hydroxybenzoate, hexadecyl 3,5-di-t-butyl-4-hydroxybenzoate, and the like.

Examples of the benzotriazole UV absorber include 2-(2-hydroxy-5-methylphenyl)2H-benzotriazole, 2-(3-t-butyl-2-hydroxy-5-n-tethylphenyl)-5-chloro-2H-benzotriazole, 2-(3,5-di-t-butyl-2-hydroxyphenyl)-5-chloro-2H-benzotriazole, 2-(3,5-di-t-butyl-2-hydroxyphenyl)-2H-benzotriazole, 5-chloro-2-(3,5-di-t-butyl-2-hydroxyphenyl)-2H-benzotriazole, 2-(3,5-di-t-amyl-2-hydroxyphenyl)-2H-benzotriazole, 2-(2-hydroxy-5-t-octylphenyl)-2H-benzotriazole, 2-(2-hydroxy-4-octylphenyl)-2H-benzotriazole, 2-(2H-benzotriazol-2-yl)-4-methyl-6-(3,4,5,6-tetrahydrophthalidylmethyl)phenol, 2,2'-methylenebis[4-(1,1,3,3-tetramethylbutyl)-6-[(2H-benzotriazol-2-yl)phenol]], and the like.

The UV absorber is normally used in an amount of 0.01 to 1 part by weight, preferably 0.02 to 0.5 parts by weight, and more preferably 0.04 to 0.3 parts by weight, based on 100 parts by weight of the alkoxysilylated polymer. The light resistance of the solar cell element encapsulating material can be improved by utilizing the UV absorber in combination with the hindered amine light stabilizer. Note that a further improvement in light resistance may not be obtained even if the UV absorber is added in an amount of more than 1 part by weight.

### Antioxidant

The antioxidant is added to improve the thermal stability of the solar cell element encapsulating material. Examples of the antioxidant include a phosphorus-based antioxidant, a phenol antioxidant, a sulfur-based antioxidant, and the like. It is preferable to use a phosphorus-based antioxidant, since coloration occurs to only a small extent.

Examples of the phosphorus-based antioxidant include monophosphite compounds such as triphenyl phosphite, diphenylisodecyl phosphite, phenyldiisodecyl phosphite, tris(nonylphenyl) phosphite, tris(dinonylphenyl) phosphite, tris(2,4-di-t-butylphenyl) phosphite, and 10-(3,5-di-t-butyl-4-hydroxybenzyl)-9,10-dihydro-9-oxa-10-phosphaphenanthrene-10-oxide, diphosphite compounds such as 4,4'-butylidenebis(3-methyl-6-t-butylphenylditridecyl) phosphite and 4,4'-isopropylidenebis(phenyldialkyl (C₁₂-C₁₅)) phosphite, 6-[3-(3-t-butyl-4-hydroxy-5-methylphenyl)propoxy]-2,4,8,10-tetrakis-t-butyldibenzo[d,f][1,3,2]dioxaphosphepin, 6-[3-(3,5-di-t-butyl-4-hydi-oxyphenyl)propoxy]-2,4,8,10-tetrakis-t-butyldibenzo[d,f][1.3.2]dioxaphosphepin, and the like.

Examples of the phenol antioxidant include pentaerythrityl-tetrakis[3-(3,5-di-t-butyl-4-hydroxyphenyl) propionate], 2,2-thiodiethylenebis[3-(3,5-di-t-butyl-4-hydroxyphenyl) propionate], octadecyl-3-(3,5-di-t-butyl-4-hydroxyphenyl) propionate, 3,9-bis{2-[3-(3-t-butyl-4-hydroxy-5-methylphenyl)[propionyloxy]]-1,1-dimethylethyl}-2,4,8,10-tetraoxaspiro[5,5]undecane, 1,3,5-trimethyl-2,4,6-tris(3,5-di-t-butyl-4-hydroxybenzyl)benzene, and the like.

Examples of the sulfur-based antioxidant include dilauryl 3,3'-thiodipropionate, dimyristyl 3,3'-thiodipropionate, distearyl 3,3'-thiodipropionate, laurylstearyl 3,3'-thiodipropionate, pentaeryththritoltetrakis(β-lauryl thiopropionate), 3,9-bis(2-dodecylthioethyl)-2,4,8,10-tetraoxaspiro[5,5]undecane, and the like.

The antioxidant is normally used in an amount of 0.01 to 1 part by weight, preferably 0.05 to 0.5 parts by weight, and more preferably 0.1 to 0.3 parts by weight, based on 100 parts by weight of the alkoxysilylated polymer. The light resistance of the solar cell element encapsulating material can be improved by utilizing the antioxidant in combination with the hindered amine light stabilizer. Note that a further improvement in light resistance may not be obtained even if the antioxidant is added in an amount of more than 1 part by weight.

The additive may be uniformly dispersed in the alkoxysilylated polymer by (i) a method that adds a solution prepared by dissolving the additive in an appropriate solvent to a solution of the hydrogenated block copolymer (i.e., precursor of modified polymer), removes the solvent, collects the hydrogenated block copolymer including the additive, and reacts the hydrogenated block copolymer with the ethylenically unsaturated silane compound in the presence of the organic peroxide, (ii) a method that melts the modified polymer using a twin-screw kneader, a roll, a Brabender, an extruder, or the like, and kneads the modified polymer and the additive, (iii) a method that kneads the additive together with the hydrogenated block copolymer and the ethylenically unsaturated silane compound when reacting the hydrogenated block copolymer and the ethylenically unsaturated silane compound in the presence of the organic peroxide, (iv) a method that mixes pellets in which the additive is uniformly dispersed in the hydrogenated block copolymer with pellets of the modified polymer, and melts and kneads the mixture to uniformly disperse the additive in the alkoxysilylated polymer, or the like.

The solar cell element encapsulating material according to one embodiment of the invention exhibits low hygroscopicity, non-hydrolyzability, excellent weatherability, excellent transparency, and excellent flexibility, and maintains excellent adhesion to glass even when exposed to a high-temperature/high-humidity environment for a long time. The solar cell element encapsulating material may suitably be used to encapsulate an electric/electronic device and the like, and may particularly suitably be used to encapsulate a solar cell element.

The solar cell element encapsulating material according to one embodiment of the invention may particularly preferably be used for a solar cell in which glass is used as a transparent front substrate.

### 4) Sheet and laminated sheet

### Sheet

A sheet according to one embodiment of the invention includes the solar cell element encapsulating material according to one embodiment of the invention.

The sheet according to one embodiment of the invention may suitably be used to produce a solar cell module.

The sheet according to one embodiment of the invention may be produced by an arbitrary method. The sheet according to one embodiment of the invention may be produced by molding the solar cell element encapsulating material according to one embodiment of the invention in the shape of a sheet. Examples of the molding method include a cast molding method, a melt extrusion molding method such as an extrusion sheet molding method and an inflation molding method, a calendar molding method, a compression molding method, and the like. Since the solar cell element encapsulating material according to one embodiment of the invention does not require addition of an organic peroxide that provides thermal crosslinkability, the melt molding temperature can be selected over a wide range.

The sheet molding conditions are appropriately selected depending on the molding method. For example, when using a melt extrusion molding method, the resin temperature is normally 180 to 240°C, preferably 190 to 230°C, and more preferably 200 to 220°C. If the resin temperature is too low, since the molded sheet may show defects (e.g., orange peel or die line) due to poor fluidity, it may be difficult to increase the sheet extrusion speed.

If the resin temperature is too high, the modified polymer may exhibit poor adhesion to glass, or the sheet may show a decrease in adhesion to glass when stored for a long time in a normal temperature/normal humidity environment due to a decrease in storage stability.

The thickness of the sheet is not particularly limited, but is normally 0.2 to 0.6 mm. When using a crystalline silicon wafer for producing a solar cell, the thickness of the silicon wafer is 0.15 to 0.2 mm. In this case, the thickness of the sheet formed of the solar cell element encapsulating material is preferably 0.3 to 0.5 mm. If the thickness of the sheet is less than 0.2 mm, glass or the solar cell element may break during a heat lamination process when producing a solar cell module. If the thickness of the sheet is more than 0.6 mm, the light transmittance of the sheet may decrease, or the economic efficiency may decrease since it is necessary to use a large amount of the solar cell element encapsulating material.

### Laminated sheet

A laminated sheet according to one embodiment of the invention includes a sheet (hereinafter may be referred to as "additive-containing sheet") that is formed of a composition, and the sheet according to one embodiment of the invention that is stacked on one side or each side of the sheet that is formed of the composition, the composition including (α) a hydrogenated block copolymer, and (β) at least one component selected from the group consisting of a polymer other than an alkoxysilyl group-containing hydrogenated block copolymer obtained by introducing an alkoxysilyl group into the hydrogenated block copolymer (α) (hereinafter may be referred to as "additional polymer"), a light stabilizer, a UV absorber, and an antioxidant, the hydrogenated block copolymer being obtained by hydrogenating 90% or more of unsaturated bonds of a block copolymer that includes at least two polymer blocks [A] and at least one polymer block [B], and the ratio (wA:wB) of the weight fraction wA of the polymer block [A] in the block copolymer to the weight fraction wB of the polymer block [B] in the block copolymer being 20:80 to 60:40.

Examples of the additional polymer, the light stabilizer, the UV absorber, and the antioxidant (hereinafter collectively referred to as "additive (2)") used for the additive-containing sheet include those mentioned above in connection with the solar cell element encapsulating material.

The additive-containing sheet may be produced in the same manner as the sheet according to one embodiment of the invention, except that the composition that includes (α) the hydrogenated block copolymer and (β) the additive (2) is used instead of the solar cell element encapsulating material.

The laminated sheet may be produced by stacking the sheet according to one embodiment of the invention on one side or each side of the additive-containing sheet using a two-material/three-layer coextrusion molding method, a method that stacks the sheet according to one embodiment of the invention on one side or each side of the additive-containing sheet by thermocompression bonding or using an adhesive, a method that applies a solution prepared by dissolving the solar cell element encapsulating material according to one embodiment of the invention in a solvent to one side or each side of the additive-containing sheet, and volatilizes the solvent, or the like.

The thickness of the laminated sheet is normally 0.001 mm or more, preferably 0.005 mm or more, and more preferably 0.01 mm or more. If the thickness of the laminated sheet is less than 0.001 mm, a decrease in adhesion to a glass substrate may occur when the laminated sheet is exposed to a high-temperature/high-humidity environment for a long time.

The sheet or the laminated sheet (hereinafter may be referred to as "sheet or the like") may have a flat shape, an embossed shape, or the like. The sheet or the like may be stored in a state in which a release film is placed on one side of the sheet or the like in order to prevent a situation in which the sheet or the like undergoes blocking. When the sheet or the like has an embossed shape, the sheet or the like cushions glass or a solar cell element from breakage during a lamination process employed when producing a solar cell module.

The sheet or the like according to one embodiment of the invention may be used for a solar cell. In this case, the sheet or the like is stacked on one side or each side of a solar cell element, and a surface protective layer is optionally stacked on the side of the sheet or the like opposite to the solar cell element.

A solar cell module may be produced by an arbitrary method. For example, a transparent front substrate formed of glass, the sheet or the like according to one embodiment of the invention, a solar cell element, a wire connected to the solar cell element, the sheet or the like according to one embodiment of the invention, and a backsheet are sequentially stacked, and then heated and laminated via vacuum suction or the like.

Since the sheet or the like according to one embodiment of the invention has a low water vapor permeability and low hygroscopicity, it is not indispensable to provide the backsheet that is used as a waterproof layer. The backsheet may be provided in order to reduce mechanical impact. A polyethylene terephthalate resin sheet, a polycarbonate resin sheet, or the like that is inexpensive and exhibits excellent mechanical strength may be used as the backsheet.

The backsheet may have a light-blocking capability and/or a light-reflecting capability in order to further improve the durability of the solar cell module produced using the sheet or the like according to one embodiment of the invention. In this case, the backsheet may contain a UV absorber or a light-blocking pigment such as titanium oxide, for example.

### 5) Multilayer sheet

A multilayer sheet according to one embodiment of the invention includes [I] a layer that includes an alkoxysilyl group-containing hydrogenated block copolymer (i) (hereinafter may be referred to as "alkoxysilylated polymer (i)"), and [II] a layer that includes a (copolymer (ii) (hereinafter may be referred to as "alkoxysilylated polyolefin (ii)") that has a melting point of 90 to 140°C and is obtained by introducing an alkoxysilyl group into a (co)polymer that is obtained by polymerizing ethylene and/or an α-olefin having 3 to 10 carbon atoms, the alkoxysilyl group-containing hydrogenated block copolymer (i) being produced by introducing an alkoxysilyl group into the above hydrogenated block copolymer, the ratio (wA:wB) of the weight fraction wA of the polymer block [A] in the block copolymer to the weight fraction wB of the polymer block [B] in the block copolymer being 40:60 to 60:40.

The alkoxysilylated polymer (i) included in the layer [I] may be produced by the method according to one embodiment of the invention using a block copolymer wherein the ratio (wA:wB) of the weight fraction wA of the polymer block [A] to the weight fraction wB of the polymer block [B] is 40:60 to 60:40.

The alkoxysilylated polyolefin (ii) included in the layer [II] is obtained by introducing an alkoxysilyl group into a polyolefin that has a melting point of 90 to 140°C and is obtained by polymerizing ethylene and/or an α-olefin having 3 to 10 carbon atoms (hereinafter may be referred to as "specific polyolefin").

Examples of the α-olefin having 3 to 10 carbon atoms include propylene, 1-butene, 1-pentene, 1-hexene, 1-heptene, 1-octene, 4-methyl-1-pentene, vinylcyclohexane, and the like.

The specific polyolefin may be synthesized by a normal method. It is also possible to use a commercially available polyolefin that has a melting point of 90 to 140°C and is produced using one or more olefins selected from the group consisting of ethylene and α-olefins having 3 to 10 carbon atoms.

The melting point of the specific polyolefin is preferably 100 to 130°C. If the melting point of the specific polyolefin is less than 90°C, heat resistance required for a solar cell may not be obtained. If the melting point of the specific polyolefin exceeds 140°C, the crystalline solar cell encapsulating temperature may not be reduced to 150°C or less that is almost equal to that when using an ethylene-vinyl acetate copolymer (EVA).

The alkoxysilyl group may be bonded directly to the specific polyolefin, or may be bonded to the specific polyolefin via a divalent organic group (e.g., alkylene group). The alkoxysilyl group is normally introduced by reacting the specific polyolefin and an ethylenically unsaturated silane compound in the presence of a peroxide.

Examples of the ethylenically unsaturated silane compound include those mentioned above that may be used when introducing the alkoxysilyl group into the hydrogenated block copolymer. It is preferable to use vinyltrimethoxysilane, vinyltriethoxysilane, allyltrimethoxysilane, allyltriethoxysilane, dimethoxymethylvinylsilane, diethoxymethylvinylsilane, or p-styryltrimethoxysilane as the ethylenically unsaturated silane compound.

These ethylenically unsaturated silane compounds may be used either alone or in combination.

The alkoxysilyl group is normally introduced into the specific polyolefin in an amount of 0.05 to 5 g/100 g, preferably 0.1 to 3 g/100 g, and more preferably 0.2 to 2 g/100 g. If the alkoxysilyl group is introduced into the specific polyolefin in too large an amount, alkoxysilyl groups that decompose due to a small amount of water or the like may be crosslinked to a large extent, so that the effect of preventing breakage of the crystalline solar cell when encapsulating the solar cell element may decrease. Whether or not the alkoxysilyl group has been introduced may be determined from the IR spectrum, and the induction amount is roughly estimated from the Si elemental analysis value.

Examples of the peroxide include those mentioned above that may be used when introducing the alkoxysilyl group into the hydrogenated block copolymer. It is preferable to use a compound having a one-minute half-life temperature of 170 to 190°C as the peroxide. For example, t-butylcumyl peroxide, dicumyl peroxide, di-t-hexyl peroxide, 2,5-dimethyl-2,5-di(t-butylperoxy)hexane, di-t-butyl peroxide, and the like are preferably used.

These peroxides may be used either alone or in combination. The peroxide is normally used in an amount of 0.05 to 2 parts by weight, preferably 0.1 to 1 part by weight, and more preferably 0.2 to 0.5 parts by weight, based on 100 parts by weight of the specific polyolefin.

A heating kneader or a reactor that may be used when introducing the alkoxysilyl group into the hydrogenated block copolymer may be used when reacting the specific polyolefin and the ethylenically unsaturated silane compound in the presence of the peroxide. For example, a mixture of the polyolefin, the ethylenically unsaturated silane compound, and the peroxide may be heated and melted at a temperature equal to or higher than the melting point of the polyolefin using a twin-screw kneader, and kneaded for a desired time.

The heating/melting temperature is normally 140 to 220°C, preferably 150 to 210°C, and more preferably 160 to 200°C.

The heating/kneading time is normally 0.1 to 10 minutes, preferably 0.2 to 5 minutes, and more preferably 0.3 to 2 minutes.

When using continuous kneading equipment such as a twin-screw kneader or a single-screw extruder, the mixture may be continuously kneaded and extruded so that the residence time is within the above range.

The content of the alkoxysilylated polymer (i) in the layer [I] is normally 80 wt% or more, preferably 90 wt% or more, and more preferably 95 wt% or more. The content of the alkoxysilylated polyolefin (ii) in the layer [II] is normally 80 wt% or more, preferably 90 wt% or more, and more preferably 95 wt% or more.

The layer [I] may include an additive for improving the performance of the solar cell element encapsulating material in addition to the alkoxysilylated polymer (i), and the layer [II] may include an additive for improving the performance of the solar cell element encapsulating material in addition to the alkoxysilylated polyolefin (ii). Note that the alkoxysilylated polymer (i) and the alkoxysilylated polyolefin (ii) may be collectively referred to as "alkoxysilylated product", Examples of the additive include an additional polymer for improving the resin properties, a light stabilizer and a UV absorber for improving weatherability, heat resistance, and the like, an antioxidant, a lubricant, an inorganic filler, and the like. It is preferable to use a light stabilizer and/or a UV absorber as the additive. These additives may be used either alone or in combination.

It is preferable that the layer [I] include a hindered amine light stabilizer in an amount of 0.1 to 5 parts by weight based on 100 parts by weight of the alkoxysilylated polymer (i), and/or the layer [II] include a hindered amine light stabilizer in an amount of 0.1 to 5 parts by weight based on 100 parts by weight of the alkoxysilylated polyolefin (ii), or the layer [I] include a UV absorber in an amount of 0.01 to 2 parts by weight based on 100 parts by weight of the alkoxysilylated polymer (i), and/or the layer [II] include a UV absorber in an amount of 0.01 to 2 parts by weight based on 100 parts by weight of the alkoxysilylated polyolefin (ii).

The light resistance of the multilayer sheet can be further improved by utilizing an antioxidant in combination with the hindered amine light stabilizer. The antioxidant is normally used in an amount of 0.01 to 1 part by weight, preferably 0.05 to 0.5 parts by weight, and more preferably 0.1 to 0.3 parts by weight, based on 100 parts by weight of the alkoxysilylated polymer (i) or the alkoxysilylated polyolefin (ii).

Examples of the ions of the hindered amine light stabilizer, the UV absorber, and the antioxidant include those mentioned above in connection with the solar cell element encapsulating material.

The additive may be uniformly dispersed in the alkoxysilylated product by an arbitrary method. For example, the additive may be uniformly dispersed in the alkoxysilylated product by a method that adds a solution prepared by dissolving the additive in an appropriate solvent to a solution of the hydrogenated block copolymer (i.e., precursor of alkoxysilylated polymer (i)), or a solution of the specific polyolefin (i.e., precursor of alkoxysilylated polyolefin (ii)), removes the solvent, collects the hydrogenated block copolymer or the specific polyolefin including the additive, and reacts the hydrogenated block copolymer or the specific polyolefin with the ethylenically unsaturated silane compound in the presence of the peroxide, a method that melts the hydrogenated block copolymer or the specific polyolefin using a twin-screw kneader, a roll, a Brabender, an extruder, or the like, and kneads the hydrogenated block copolymer or the specific polyolefin with the additive, and reacts the hydrogenated block copolymer or the specific polyolefin with the ethylenically unsaturated silane compound in the presence of the peroxide, a method that kneads the additive together with the hydrogenated block copolymer or the specific polyolefin and the ethylenically unsaturated silane compound when reacting the hydrogenated block copolymer or the specific polyolefin with the ethylenically unsaturated silane compound in the presence of the peroxide, a method that mixes pellets in which the additive is uniformly dispersed in the hydrogenated block copolymer or the specific polyolefin with pellets of the alkoxysilylated polymer or the alkoxysilylated polyolefin, and melts and kneads the mixture to uniformly disperse the additive in the alkoxysilylated product, or the like.

The multilayer sheet according to one embodiment of the invention may suitably be used to produce a solar cell module.

The thickness of the multilayer sheet is not particularly limited, but is preferably 0.2 to 0.8 mm. When using a crystalline silicon wafer for producing a solar cell, the thickness of the multilayer sheet is preferably 0.3 to 0.7 mm, and more preferably 0.4 to 0.6 mm. The above range is preferable for the reason stated above.

The thickness of each layer included in the multilayer sheet according to one embodiment of the invention is not particularly limited. It is preferable to use the layer [I] as the outermost layer. The thickness of the layer [I] used as the outermost layer is normally 0.07 to 0.3 mm, preferably 0.09 to 0.25 mm, and more preferably 0.1 to 0.2 mm.

If the thickness of the layer [I] used as the outermost layer is less than 0.07 mm, the effect of preventing cracks in a crystalline solar cell in a heat cycle test may decrease. If the thickness of the layer [I] used as the outermost layer exceeds 0.3 mm, the effect of preventing breakage of a crystalline solar cell during a vacuum lamination process may be insufficient.

The thickness of the layer [II] is normally 0.05 to 0.3 mm, preferably 0.08 to 0.25 mm, and more preferably 0.11 to 0.2 mm.

If the thickness of the layer [II] is less than 0.05 mm, the effect of preventing breakage of a crystalline solar cell during a vacuum lamination process may be insufficient. If the thickness of the layer [II] exceeds 0.3 mm, the light transmittance of the multilayer sheet may decrease.

The multilayer sheet may have a two-layer configuration that includes the layer [I] and the layer [II], a three-layer configuration that sequentially includes the layer [I], the layer [II], and the layer [I], a four-layer configuration that sequentially includes the layer [I], the layer [II], the layer [I], and the layer [II], a five-layer configuration that sequentially includes the layer [I], the layer [II], the layer [I], the layer [II], and the layer [I], a configuration in which an additional resin layer is provided between the layer [I] and the layer [II], or the like. It is preferable that the multilayer sheet have a two-layer configuration that includes the layer [I] and the layer [II], or a three-layer configuration that sequentially includes the layer [I], the layer [II], and the layer [I], from the viewpoint of industrial production.

The multilayer sheet according to one embodiment of the invention may be produced by an arbitrary method. For example, the multilayer sheet according to one embodiment of the invention may be produced by a method that molds the multilayer sheet by a known multilayer coextrusion molding method using a layer [I]-forming composition (i.e., a composition that includes the alkoxysilylated polymer (i), or a composition in which the additive is dispersed in the alkoxysilylated polymer (i)) and a layer [II]-forming composition (i.e., a composition that includes the alkoxysilylated polyolefin (ii), or a composition in which the additive is dispersed in the alkoxysilylated polyolefin (ii)), a method that stacks and thermocompression-bonds one or more layers [I] that are formed by a melt extrusion method or the like using the layer [I]-forming composition and one or more layers [II] that are formed by a melt extrusion method or the like using the layer [II]-forming composition, a method that applies a solution prepared by dissolving the layer [I]-forming composition in a solvent to one side or each side of the layer [II] obtained as described above, and volatilizes the solvent, or the like.

Since the multilayer sheet according to one embodiment of the invention does not require addition of an organic peroxide that provides thermal crosslinkability, the melt molding temperature can be selected over a wide range. The multilayer sheet molding conditions are appropriately selected depending on the molding method. For example, when using a melt extrusion molding method, the resin temperature is normally 150 to 210°C, preferably 160 to 200°C, and more preferably 170 to 190°C.

If the resin temperature is too low, the surface flatness of the multilayer sheet may decrease due to poor fluidity. Moreover, since it may be difficult to increase the sheet extrusion speed, industrial productivity may deteriorate.

If the resin temperature is too high, the alkoxysilylated polymer (i) and/or the alkoxysilylated polyolefin may exhibit poor adhesion to glass, or an excellent multilayer sheet may not be obtained due to gelation, or the multilayer sheet may show a decrease in adhesion to glass when stored for a long time in a normal temperature/normal humidity environment due to a decrease in storage stability.

The multilayer sheet according to one embodiment of the invention may have a flat shape, an embossed shape, or the like. The multilayer sheet may be stored in a state in which a release film is placed on one side of the multilayer sheet in order to prevent a situation in which the multilayer sheet undergoes blocking, When the multilayer sheet has an embossed shape, the multilayer sheet cushions glass or a solar cell element from breakage during a lamination process employed when producing a solar cell module.

The multilayer sheet according to one embodiment of the invention may be used for a solar cell. In this case, the multilayer sheet is stacked on one side or each side of a solar cell element, and a surface protective layer is optionally stacked on the side of the multilayer sheet opposite to the solar cell element.

A solar cell module may be produced by an arbitrary method. For example, a transparent front substrate formed of glass, the multilayer sheet according to one embodiment of the invention, a solar cell element, a tab wire connected to the solar cell element, the multilayer sheet according to one embodiment of the invention, and a backsheet are sequentially stacked, and then heated and laminated via vacuum suction or the like.

It is preferable that the multilayer sheet according to one embodiment of the invention be configured so that at least one outermost layer is formed by the layer [I]. The multilayer sheet according to one embodiment of the invention may suitably be used as an encapsulating material for a solar cell element (preferably a crystalline solar cell element) in which glass is used as a transparent front substrate. Since the multilayer sheet according to one embodiment of the invention has a low water vapor permeability and low hygroscopicity, it is not indispensable to provide the backsheet that is used as a waterproof layer. The backsheet may be provided in order to reduce mechanical impact. A polyethylene terephthalate (PET) resin sheet, a polycarbonate resin sheet, or the like that is inexpensive and exhibits excellent mechanical strength may be used as the backsheet.

The backsheet may have a light-blocking capability and/or a light-reflecting capability in order to further improve the durability of the solar cell module produced using the multilayer sheet according to one embodiment of the invention. In this case, the backsheet may contain a UV absorber or a light-blocking pigment such as titanium oxide, for example.

The multilayer sheet according to one embodiment of the invention is useful as a solar cell element encapsulating material. Note that the multilayer sheet according to one embodiment of the invention may also be used to bond glass sheets, bond a glass sheet and a metal sheet, bond metal sheets, or encapsulate an electronic part, for example.

### 6) Method for encapsulating solar cell element

A method for encapsulating a solar cell element according to one embodiment of the invention includes disposing the multilayer sheet according to one embodiment of the invention so that the layer [I] of the multilayer sheet comes in contact with a solar cell element. It is possible to prevent breakage of the solar cell element (particularly a crystalline solar cell element) during a vacuum lamination process by disposing the multilayer sheet so that the layer [I] of the multilayer sheet comes in contact with the solar cell element. It is also possible to prevent cracks in the solar cell element (particularly a crystalline solar cell element) even when the solar cell element is subjected to a heat cycle test at -40°C to +90°C (i.e., a normal solar cell module environmental test).

When the transparent front substrate of the solar cell module is made of glass, it is preferable to dispose the multilayer sheet so that the layer [I] of the multilayer sheet comes in contact with glass. The multilayer sheet according to one embodiment of the invention exhibits low hygroscopicity, a low water vapor permeability, transparency, weatherability, flexibility, heat resistance, and a low-temperature encapsulating capability, maintains excellent adhesion to glass even when exposed to a high-temperature/high-humidity environment for a long time, and may be used to encapsulate a solar cell element without applying a special waterproof treatment.

Since the multilayer sheet according to one embodiment of the invention exhibits sufficient heat resistance even if the multilayer sheet is not crosslinked and cured using a crosslinking agent (e.g., organic peroxide), a crosslinking step can be omitted from the solar cell production process.

### EXAMPLES

The invention is further described below by way of examples and comparative examples. Note that the invention is not limited to the following examples. In the examples and comparative examples, the unit "parts" refers to "parts by weight", and the unlit "%" refers to "wt%", unless otherwise indicated.
The property measurement methods employed in the examples and comparative examples are described below.

### (1) Weight average molecular weight (Mw) and molecular weight distribution

### (Mw/Mn)

The molecular weight (standard polystyrene-reduced value) of the block copolymer and the hydrogenated block copolymer was measured by GPC at 38°C using THF as an eluant. An HLC-8020 GPC system (manufactured by Tosoh Corporation) was used for the measurement.

### (2) Hydrogenation rate

The hydrogenation rate of the main chain, the side chain, and the aromatic ring of the hydrogenated block copolymer was calculated from the ¹H-NMR spectrum.

### (3) Light transmittance

The extrusion-molded sheet of the solar cell element encapsulating material, the extrusion-molded sheet of the alkoxysilylated polymer (i) and/or the alkoxysilylated polyolefin (ii), or the multilayer sheet of the extrusion-molded sheet was heated and pressed at 150°C for 10 minutes using a vacuum laminator ("PVL0202S" manufactured by Nisshinbo Mechatronics Inc.), and the light transmittance was measured in accordance with ASTM D-1003.

### (4) Water vapor permeability

The extrusion-molded sheet of the solar cell element encapsulating material, the extrusion-molded sheet of the alkoxysilylated polymer (i) and/or the alkoxysilylated polyolefin (ii), or the multilayer sheet of the extrusion-molded sheet was heated and pressed at 150°C for 10 minutes using the vacuum laminator to prepare a specimen having a thickness of 300 to 350 µm, and the water vapor permeability of the specimen was measured at 40°C and 90%RH in accordance with JIS Z 0208. The measured value was converted into a value at a thickness of 300 µm in order to accurately determine the properties of the sheet material.

### (5) Tensile modulus, tensile strength, and tensile elongation

The extrusion-molded sheet of the solar cell element encapsulating material, the extrusion-molded sheet of the alkoxysilylated polymer (i) and/or the alkoxysilylated polyolefin (ii), or the multilayer sheet of the extrusion-molded sheet was heated and pressed at 150°C for 10 minutes using the vacuum laminator, and the tensile modulus, the tensile strength, and the tensile elongation were measured using a Tensilon universal tester ("RTC-1125A" manufactured by ORIENTIC) in accordance with JIS K 7127/5/200. A tensile test was performed at a temperature of 23°C and a chuck-to-chuck distance of 10 cm using a type-5 specimen until breakage occurred. The tensile modulus was measured in accordance with JIS K. 7161, the strength at which breakage occurred was taken as the tensile strength, and the elongation at which breakage occurred was taken as the tensile elongation.

### (6) Volume resistivity

Three extrusion-molded sheets of the solar cell element encapsulating material were stacked and laminated using the vacuum laminator to obtain a specimen having a thickness of 0.9 to 1.1 mm, and the volume resistivity of the specimen was measured at 23°C in accordance with JIS K 6911.

Note that the extrusion-molded sheet of the alkoxysilylated polymer (i) and/or the alkoxysilylated polyolefin (ii), or the multilayer sheet of the extrusion-molded sheet was prepared into a specimen having a thickness of 1.1 to 1.3 mm.

### (7) Adhesion to glass substrate (peeling strength)

The extrusion-molded sheet of the solar cell element encapsulating material, the extrusion-molded sheet of the alkoxysilylated polymer (i) and/or the alkoxysilylated polyolefin (ii), or the multilayer sheet of the extrusion-molded sheet was stacked on a soda lime glass substrate (thickness: 2 mm, width: 25 mm, and length: 65 mm) so that the end of the sheet had a non-bonding area, heated and pressed at 50°C for 10 minutes, and then heated and pressed (bonded) at 180°C for 10 minutes using the vacuum laminator, to prepare a peeling test specimen. The surface of the sheet was cut at intervals of 10 mm, and subjected to a 90° peeling test at a peeling rate of 50 mm/min in accordance with JIS K 6854-1 to measure the peeling strength. The initial peeling strength after the specimen had been subjected to the vacuum lamination process, and the peeling strength after the specimen had been subjected to a high-temperature/high-humidity environment of 85°C and 85%RH for 1000 hours were measured. The higher the peeling strength, the better the adhesion to glass is.

### (8) Weatherability

The specimen that was prepared for evaluating adhesion to a glass substrate and obtained by bonding glass and the extrusion-molded sheet of the solar cell element encapsulating material, was used. A white PET film ("Lumirror (registered trademark) E20" manufactured by Toray Industries Inc., thickness: 125 µm) was placed on the back side (extrusion-molded sheet) of the specimen, light was applied to the specimen thorough the glass side for 300 hours using a sunshine weatherometer ("WEL-SU N-HC-B" manufactured by Suga Test Instruments Co., Ltd.) (sunshine carbon arc lamp, black panel temperature: 63°C, relative humidity: 50%), and the light transmittance of the specimen was measured.

The extrusion-molded sheet of the alkoxysilylated polymer (i) and/or the alkoxysilylated polyolefin (ii), or the multilayer sheet of the extrusion-molded sheet was placed between soda-lime glass substrates (thickness: 2 mms, width: 25 mm, length: 65 mm), heated and pressed (bonded) at 150°C for 10 minutes using the vacuum laminator to prepare a specimen. The light transmittance (wavelength: 500 nm) of the specimen was measured as described above.

### (9) Corrosion resistance of encapsulated copper sheet

A copper sheet (thickness: 0.3 mm) from which the surface oxide had been removed by etching using an acetic acid aqueous solution, and washing with water, was placed between two extrusion-molded sheets of the solar cell element encapsulating material, or two extrusion-molded sheets of the alkoxysilylated polymer (i) and/or the alkoxysilylated polyolefin (ii), and heated and pressed at 150°C for 10 minutes using the vacuum laminator to prepare a corrosion resistance evaluation specimen in which the copper sheet was encapsulated. The specimen was allowed to stand at a temperature of 85°C and a relative humidity of 85% for 1 week, and the appearance of the specimen, the presence or absence of an odor, and discoloration of the copper foil (sheet) were observed.

### (10) Durability of solar cell module (Examples 1 to 5)

A sheet formed of the solar cell element encapsulating material was placed on a transparent substrate (soda-lime glass), and a polycrystalline silicon solar cell was placed on the sheet. A copper foil wire was connected to the solar cell. A sheet formed of the solar cell element encapsulating material and a backsheet (PET) were sequentially placed on the solar cell to obtain a laminate. The laminate was heated and pressed (encapsulated) using the vacuum laminator to obtain a solar cell module.

The solar cell module was subjected to a heat cycle test (200 cycles) (1 cycle: -40°C for 30 minutes and 90°C for 30 minutes). The presence or absence of deformation of the solar cell module was observed with the naked eye, and five solar cells were observed using a C-mode ultrasonic scanning microscope (manufactured by SONIX) to determine the presence or absence of cracks. A case where deformation and cracks were not observed was evaluated as "Acceptable".

### (11) Presence or absence of cracks in cells during production of solar cell module, and durability of solar cell module (Examples 6 to 11)

A sheet formed of the alkoxysilylated polymer (i) and/or the alkoxysilylated polyolefin (ii) was placed on a transparent substrate (soda-lime glass, 200×200 mm, thickness: 3 mm), and a polycrystalline silicon solar cell (manufactured byAdvantec Co., Ltd., 155×155 mm, thickness: 200 µm) (a tab wire obtained by soldering a copper wire (thickness: 200 µm) was connected to each side of the solar cell) was placed on the sheet. A sheet formed of the alkoxysilylated polymer (i) and/or the alkoxysilylated polyolefin (ii) and a PET release film were sequentially placed on the solar cell to obtain a laminate. The laminate was degassed at 145 to 160°C for 5 minutes under vacuum, and then pressed (encapsulated) for 10 minutes under vacuum using the vacuum laminator to obtain a solar cell module.

After removing the release film from the solar cell module, the presence or absence of cracks in five solar cells was observed with the naked eye. A case where cracks were not observed in each solar cell was evaluated as "Acceptable". When cracks were observed, the number of cells in which cracks occurred was counted.

A typical vacuum lamination temperature currently employed for EVA is 150°C. Therefore, cracks should not occur at 150°C.

The solar cell module which was produced as described above and in which cracks were not observed in each solar cell, was subjected to a heat cycle test (200 cycles) (1 cycle: -40°C for 30 minutes and 90°C for 30 minutes), and five solar cells were observed with the naked eye and using a C-mode ultrasonic scanning microscope (manufactured by SONIX) to determine the presence or absence of cracks. A case where deformation and cracks were not observed in each solar cell was evaluated as "Acceptable".

### Reference Example 1

### Synthesis of hydrogenated block copolymer resin composition [A2]

A reactor which was equipped with a stirrer and of which the internal atmosphere had been sufficiently replaced with nitrogen, was charged with 550 parts of dehydrated cyclohexane, 25.0 parts of dehydrated styrene, and 0.475 parts of n-dibutyl ether. 0.68 parts of n-butyllithium (15% cyclohexane solution) was added to the mixture at 60°C with stirring to initiate polymerization. The mixture was reacted at 60°C for 60 minutes with stirring. The polymerization conversion rate was then measured by gas chromatography, and found to be 99.5%.

After the addition of 50.0 parts of dehydrated isoprene, the mixture was stirred for 30 minutes. The polymerization conversion rate was then measured, and found to be 99%.

After the addition of 25.0 parts of dehydrated styrene, the mixture was stirred for 60 minutes. The polymerization conversion rate was then measured, and found to be about 100%. The reaction was then terminated by adding 0.5 parts of isopropyl alcohol.

The resulting block copolymer (a) had a weight average molecular weight (Mw) of 61,700 and a molecular weight distribution (Mw/Mn) of 1.05.

The polymer solution was transferred to a pressure-resistant reactor equipped with a stirrer. After the addition of 3.0 parts of a nickel catalyst supported on a silica-alumina carrier ("T-8400RL", manufactured by Süd-Chemie) (hydrogenation catalyst) and 100 parts of dehydrated cyclohexane, the components were mixed. After replacing the internal atmosphere of the reactor with hydrogen gas, hydrogen was supplied to the reactor while stirring the solution to effect a hydrogenation reaction at a temperature of 170°C and a pressure of 4.5 MPa for 6 hours.

The resulting hydrogenated block copolymer (A) had a weight average molecular weight (Mw) of 65,300 and a molecular weight distribution (Mw/Mn) of 1.06.

After removing the hydrogenation catalyst by filtering the reaction solution, 1.0 part of a xylene solution of 0.1 parts of 6-[3-(3-t-butyl-4-hydroxy-5-methylphenyl)propoxy]-2,4,8,10-tetrakis-t-butyldibenzo[d, f][1.3.2]dioxaphosphepin ("Sumilizer (registered trademark) GP" manufactured by Sumitomo Chemical Co., Ltd.) (phosphorus-based antioxidant) was added to and dissolved in the reaction solution.

After filtering the solution through a metal fiber filter (manufactured by Nichidai Corporation, pore size: 0.4 µm) to remove minute solids, the solvent (cyclohexane and xylene) and other volatile components were removed from the solution at a temperature of 260°C and a pressure of 0.001 MPa or less using a cylindrical evaporator ("Kontro" manufactured by Hitachi Ltd.). The residue was extruded in the shape of a strand in a molten state from a die connected to the evaporator, cooled, and cut using a pelletizer to obtain 90 parts of pellets of a hydrogenated block copolymer [A1]. The resulting hydrogenated block copolymer [A1] had a weight average molecular weight (Mw) of 64,600 and a molecular weight distribution (Mw/Mn) of 1.11. The hydrogenation rate of the hydrogenated block copolymer [A1] was about 100%.

1.0 part of a polymer of N,N'-bis(2,2,6,6-tetramethyl-4-piperidinyl)-1,6-hexanediamine and 2,4,6-trichloro-1,3,5-triazine and a reaction product of n-butyl-1-butaneamine and N-butyl-2,2,6,6-tetramethyl-4-piperidineamine ("Chimassorb (registered trademark) 2020" manufactured by BASF Japan Ltd,) (hindered amine light stabilizer), and 0.05 parts of 2-(2H-benzotriazol-2-yl)-4-(1,1,3,3-tetramethylbutyl)phenol ("Tinuvin (registered trademark) 329" manufactured by BASF Japan Ltd.) (benzotriazole UV absorber) were added to 100 parts of the pellets of the hydrogenated block copolymer [A1]. The mixture was kneaded at a resin temperature of 250°C using a twin-screw kneader ("TEM-35B" manufactured by Toshiba Machine Co., Ltd.), extruded in the shape of a strand, cooled with water, and cut using a pelletizer to obtain 98 parts of pellets of a hydrogenated block copolymer resin composition [A2].

### Reference Example 2

### Synthesis of hydrogenated block copolymer resin composition [B2]

92 parts of pellets of a hydrogenated block copolymer [B1] were obtained in the same manner as in Reference Example 1, except that 15.0 parts of styrene, 0.50 parts of n-butyllithium (15% cyclohexane solution), 70.0 parts of isoprene, and 15.0 parts of styrene were sequentially added to the reaction system, and polymerized as the monomers. The resulting hydrogenated block copolymer [B1] had a weight average molecular weight (Mw) of 86,200 and a molecular weight distribution (Mw/Mn) of 1.15. The hydrogenation rate of the hydrogenated block copolymer [B1] was about 100%.

1.0 part of the hindered amine light stabilizer and 0.05 parts of the benzotriazole UV absorber used in Reference Example 1 were added to 100 parts of the pellets of the hydrogenated block copolymer [B1], and the components were kneaded in the same manner as in Reference Example 1 to obtain 98 parts of pellets of a hydrogenated block copolymer resin composition [B2].

### Reference Example 3

### Synthesis of hydrogenated block copolymer resin composition [C2]

90 parts of pellets of a hydrogenated block copolymer [C1] were obtained in the same manner as in Reference Example 1, except that 20.0 parts of styrene, 0.55 parts of n-butyllithium (15% cyclohexane solution), 60.0 parts of isoprene, and 20.0 parts of styrene were sequentially added to the reaction system, and polymerized as the monomers. The resulting hydrogenated block copolymer [C1] had a weight average molecular weight (Mw) of 79,500 and a molecular weight distribution (Mw/Mn) of 1.15. The hydrogenation rate of the hydrogenated block copolymer [C1] was about 100%.

1.0 part of the hindered amine light stabilizer and 0.05 parts of the benzotriazole UV absorber used in Reference Example 1 were added to 100 parts of the pellets of the hydrogenated block copolymer [C1], and the components were kneaded in the same manner as in Reference Example 1 to obtain 98 parts of pellets of a hydrogenated block copolymer resin composition [C2].

### Reference Example 4

### Synthesis of hydrogenated block copolymer resin composition [D2]

88 parts of pellets of a hydrogenated block copolymer [D1] were obtained in the same manner as in Reference Example 1, except that 25.0 parts of styrene, 50.0 parts of liquefied butadiene instead of isoprene, and 25.0 parts of styrene were sequentially added to the reaction system, and polymerized as the monomers. The resulting hydrogenated block copolymer [D1] had a weight average molecular weight (Mw) of 64,000 and a molecular weight distribution (Mw/Mn) of 1.11. The hydrogenation rate of the hydrogenated block copolymer [D1] was about 100%.

1.0 part of the hindered amine light stabilizer and 0.05 parts of the benzotriazole UV absorber used in Reference Example I were added to 100 parts of the pellets of the hydrogenated block copolymer [D1], and the components were kneaded in the same manner as in Reference Example 1 to obtain 97 parts of pellets of a hydrogenated block copolymer resin composition [D2].

### Reference Example 5

### Synthesis of hydrogenated block copolymer resin composition [E2]

78 parts of pellets of a hydrogenated block copolymer [E1] were obtained in the same manner as in Reference Example 1, except that 5.0 parts of styrene, 90.0 parts of isoprene, and 5.0 parts of styrene were sequentially added to the reaction system, and polymerized as the monomers. The resulting hydrogenated block copolymer [E1] had a weight average molecular weight (Mw) of 60,300 and a molecular weight distribution (Mw/Mn) of 1.10. The hydrogenation rate of the hydrogenated block copolymer [E1] was about 100%.

1.0 part of the hindered amine light stabilizer and 0.05 parts of the benzotriazole UV absorber used in Reference Example 1 were added to 100 parts of the pellets of the hydrogenated block copolymer [E1], and the components were kneaded in the same manner as in Reference Example 1 to obtain 95 parts of pellets of a hydrogenated block copolymer resin composition [E2].

### Reference Example 6

### Synthesis of hydrogenated block copolymer resin composition [F2]

96 parts of pellets of a hydrogenated block copolymer [F1] were obtained in the same manner as in Reference Example 1, except that 37.5 parts of styrene, 25.0 parts of isoprene, and 37.5 parts of styrene were sequentially added to the reaction system, and polymerized as the monomers. The resulting hydrogenated block copolymer [F1] had a weight average molecular weight (Mw) of 66,300 and a molecular weight distribution (Mw/Mn) of 1.10. The hydrogenation rate of the hydrogenated block copolymer [F1] was about 100%.

1.0 part of the hindered amine light stabilizer and 0.05 parts of the benzotriazole UV absorber used in Reference Example 1 were added to 100 parts of the pellets of the hydrogenated block copolymer [F1], and the components were kneaded in the same manner as in Reference Example 1 to obtain 95 parts of pellets of a hydrogenated block copolymer resin composition [F2].

### Example 1

### Solar cell element encapsulating material [A3] and sheet [SA3]

2.0 parts of vinyltrimethoxysilane and 0.2 parts of di-t-butyl peroxide were added to 100 parts of the pellets of the resin composition [A2] obtained in Reference Example 1. The mixture was kneaded at a resin temperature of 210°C for a residence time of 80 to 90 seconds using a twin-screw extruder ("TEM-37B" manufactured by Toshiba Machine Co., Ltd.), extruded in the shape of a strand, cooled with air, and cut using a pelletizer to obtain 97 parts of pellets of an alkoxysilylated polymer-containing solar cell element encapsulating material [A3].

After dissolving 10 parts of the pellets of the solar cell element encapsulating material [A3] in 100 parts of cyclohexane, the solution was poured into 400 parts of dehydrated methanol to coagulate the alkoxysilylated polymer. The alkoxysilylated polymer was filtered off, and dried at 25°C under vacuum to isolate 9.5 parts of the alkoxysilylated polymer.

The FT-IR spectrum of the resulting alkoxysilylated polymer was measured. An absorption peak attributed to an Si-OCH₃ group was observed at 1090 cm⁻¹, and an absorption peak attributed to an Si-CH₂ group was observed at 825 cm⁻¹ and 739 cm⁻¹. These absorption peaks differ from those (1075 cm⁻¹, 808 cm⁻¹, 766 cm⁻¹) of vinyltrimethoxysilane.

0.3% of Si was detected as a result of subjecting the alkoxysilylated polymer to elemental analysis.

It was thus confirmed that the solar cell element encapsulating material [A3] contained an alkoxysilylated polymer into which an alkoxysilyl group was introduced.

### Extrusion molding

The pellets of the solar cell element encapsulating material [A3] were heated at 50°C for 4 hours using a hot-blast dryer to remove dissolved air. The solar cell element encapsulating material [A3] was extrusion-molded from two resin melt extruders (screw diameter: 25 mm) of a T-die two-material/three-layer film melt extrusion molding machine (T-die width: 300 mm) at a molten resin temperature of 210°C, a T-die temperature of 210°C, and a roll temperature of 50°C to obtain an extruded sheet [SA3] having a thickness of 350 µm and a width of 280 mm. The resulting extruded sheet [SA3] was wound around a roll.

### Vacuum press molding

The extruded sheet [SA3] was cut to dimensions of 200×200 mm. Three sheets were stacked, degassed at 180°C for 5 minutes under vacuum using the vacuum laminator, and vacuum-pressed for 10 minutes to obtain a specimen having a thickness of 0.9 to 1.1 mm.

A glass substrate adhesion evaluation specimen and a solar cell module durability evaluation specimen were prepared by degassing the stacked sheets at 180°C for 5 minutes under vacuum using the vacuum laminator, and vacuum-pressing the stacked sheets for 10 minutes.

### Evaluation of solar cell element encapsulating material

The light transmittance, the water vapor permeability, the tensile strength, the tensile elongation, the volume resistivity, the initial adhesion to a glass substrate, the adhesion to a glass substrate after being subjected to a high-temperature/high-humidity environment, the corrosion resistance and the weatherability of the encapsulated copper sheet, and the durability of the solar cell module were evaluated using the extruded sheet [SA3] and the vacuum press-molded specimen. The results are shown in Table 1.

### Example 2

### Multilayer sheet [MSA3] of solar cell element encapsulating material [A3]

Dissolved air was removed in the same manner as in Example 1 from the pellets of the solar cell element encapsulating material [A3] obtained in Example 1 and the pellets of the resin composition [A2] obtained in Reference Example 1. The solar cell element encapsulating material [A3] (outer layer) and the resin composition [A2] (inner layer) were extrusion-molded separately from the extruders of the two-material/three-layer film melt extrusion molding machine used in Example 1 at a molten resin temperature of 210°C, a T-die temperature of 210°C, and a roll temperature of 50°C to obtain a sheet [MSA3] having a thickness of 400 µm and a width of 280 mm. The resulting sheet [MSA3] was wound around a roll.

A vacuum press-molded specimen was prepared in the same manner as in Example 1 using the sheet [MSA3], and the light transmittance, the water vapor permeability, the tensile strength, the tensile elongation, the initial adhesion to a glass substrate, the adhesion to a glass substrate after being subjected to a high-temperature/high-humidity environment, the corrosion resistance and the weatherability of the encapsulated copper sheet, and the durability of the solar cell module were evaluated as described above. The results are shown in Table 1.

### Example 3

### Solar cell element encapsulating material [B3] and sheet [SB3]

2.0 parts of vinyltrimethoxysilane and 0.2 parts of di-t-butyl peroxide were added to 100 parts of the pellets of the resin composition [B2] obtained in Reference Example 2. The mixture was kneaded in the same manner as in Example 1 to obtain 96 parts of pellets of a solar cell element encapsulating material [B3].

The FT-IR spectrum of the resulting pellets was measured. An absorption peak attributed to an Si-OCH₃ group was observed at 1090 cm⁻¹, and an absorption peak attributed to an Si-CH₂ group was observed at 825 cm⁻¹ and 739 cm⁻¹ in the same manner as in Example 1. It was thus confirmed that the resin composition [B3] contained a silane-modified polymer.

An extruded sheet [SB3] and a vacuum press-molded specimen were prepared in the same manner as in Example 1 using the solar cell element encapsulating material [B3], and the light transmittance, the water vapor permeability, the tensile strength, the tensile elongation, the volume resistivity, the initial adhesion to a glass substrate, the adhesion to a glass substrate after being subjected to a high-temperature/high-humidity environment, the corrosion resistance and the weatherability of the encapsulated copper sheet, and the durability of the solar cell module were evaluated as described above. The results are shown in Table 1.

### Example 4

### Solar cell element encapsulating material [C3] and sheet [SC3]

2.0 parts of vinyltrimethoxysilane and 0.2 parts of di-t-butyl peroxide were added to 100 parts of the pellets of the resin composition [C2] obtained in Reference Example 3. The mixture was kneaded in the same manner as in Example 1 to obtain 97 parts of pellets of a solar cell element encapsulating material [C3].

The FT-IR spectrum of the resulting pellets was measured. An absorption peak attributed to an Si-OCH₃ group was observed at 1090 cm⁻¹, and an absorption peak attributed to an Si-CH₂ group was observed at 825 cm⁻¹ and 739 cm⁻¹ in the same manner as in Example 1. It was thus confirmed that the solar cell element encapsulating material [C3] contained a silane-modified polymer.

An extruded sheet [SC3] and a vacuum press-molded specimen were prepared in the same manner as in Example 1 using the solar cell element encapsulating material [C3], and the light transmittance, the water vapor permeability, the tensile strength, the tensile elongation, the volume resistivity, the initial adhesion to a glass substrate, the adhesion to a glass substrate after being subjected to a high-temperature/high-humidity environment, the corrosion resistance and the weatherability of the encapsulated copper sheet, and the durability of the solar cell module were evaluated as described above. The results are shown in Table 1.

### Example 5

### Solar cell element encapsulating material [D3] and sheet [SD3]

2.0 parts of vinyltrimethoxysilane and 0.2 parts of di-t-butyl peroxide were added to 100 parts of the pellets of the resin composition [D2] obtained in Reference Example 4. The mixture was kneaded in the same manner as in Example 1 to obtain 96 parts of pellets of a solar cell element encapsulating material [D3].

The FT-IR spectrum of the resulting pellets was measured. An absorption peak attributed to an Si-OCH₃ group was observed at 1090 cm⁻¹, and an absorption peak attributed to an Si-CH₂ group was observed at 825 cm⁻¹ and 739 cm⁻¹ in the same manner as in Example 1. It was thus confirmed that the solar cell element encapsulating material [D3] contained a silane-modified polymer.

An extruded sheet [SD3] and a vacuum press-molded specimen were prepared in the same manner as in Example 1 using the solar cell element encapsulating material [D3], and the light transmittance, the water vapor permeability, the tensile strength, the tensile elongation, the volume resistivity, the initial adhesion to a glass substrate, the adhesion to a glass substrate after being subjected to a high-temperature/high-humidity environment, the corrosion resistance and the weatherability of the encapsulated copper sheet, and the durability of the solar cell module were evaluated as described above. The results are shown in Table 1.

### Comparative Example 1

### 1.0 part of a polymer of

N,N'-bis(2,2,6,6-tetramethyl-4-piperidinyl)-1,6-hexanediamine and 2,4,6-trichloro-1,3,5-triazine and a reaction product of N-butyl-1-butaneamine and N-butyl-2,2,6,6-tetramethyl-4-piperidineamine, and 0.05 parts of 2-(2H-benzotriazol-2-yl)-4-(1,1,3,3-tetramethylbutyl)phenol used in Reference Example 1, were added to 100 parts of an ethylene-vinyl acetate copolymer ("Evaflex (registered trademark) EV250" manufactured by Du Pont-Mitsui Polychemicals Co., Ltd., vinyl acetate content: 28 wt%). After the addition of 0.1 parts of 2,5-dimethyl-2,5-di(t-butylperoxy)hexane ("Perhexa (registered trademark) 25B" manufactured by NOF Corporation) (organic peroxide), 0.5 parts of triallyl isocyanurate ("M-60" manufactured by Nippon Kasei Chemical Co., Ltd.) (crosslinking promoter), and 1.0 part of 3-methacryloxypropyltrimethoxysilane ("KBM-503" manufactured by Shin-Etsu Chemical Co., Ltd.) (silane coupling agent), the mixture was kneaded at a resin temperature of 100°C using a twin-screw kneader, extruded in the shape of a strand, cooled with air, and cut using a pelletizer to obtain 94 parts of pellets of a solar cell element encapsulating material [EVA2].

### Extrusion molding

The pellets of the solar cell element encapsulating material [EVA2] were extrusion-molded from the extruders of the extrusion molding machine used in Example 1 at a molten resin temperature of 100°C, a T-die temperature of 100°C, and a roll temperature of 25°C to obtain a sheet [SEVA2] having a thickness of 350 µm and a width of 280 mm. The resulting sheet [SEVA2] was wound around a roll.

### Vacuum press molding

The sheet [SEVA2] was cut to dimensions af 200×200 mm. Three sheets were stacked, degassed at 150°C for 5 minutes under vacuum using the vacuum laminator, and vacuum-pressed for 20 minutes to obtain a specimen [SEVA3] having a thickness of 300 to 350 µm and a thickness of 0.9 to 1.1 mm.

A glass substrate adhesion evaluation specimen and a solar cell module durability evaluation specimen were prepared by degassing the sheet [SEVA2] at 150°C for 10 minutes under vacuum using the vacuum laminator, and vacuum-pressing the sheet for 20 minutes.

### Evaluation of solar cell element encapsulating material

The light transmittance, the water vapor permeability, the tensile strength, the tensile elongation, the volume resistivity, the initial adhesion to a glass substrate, the adhesion to a glass substrate after being subjected to a high-temperature/high-humidity environment, the corrosion resistance and the weatherability of the encapsulated copper sheet, and the durability of the solar cell module were evaluated using the resulting specimen. The results are shown in Table 1.

### Comparative Example 2

### Solar cell element encapsulating material [E3] and sheet [SE3]

2.0 parts of vinyltrimethoxysilane and 0.2 parts of di-t-butyl peroxide were added to 100 parts of the pellets of the resin composition [E2] obtained in Reference Example 5. The mixture was kneaded in the same manner as in Example 1 to obtain 96 parts of pellets of a solar cell element encapsulating material [E3].

The FT-IR spectrum of the resulting pellets was measured. An absorption peak attributed to an Si-OCH₃ group was observed at 1090 cm⁻¹, and an absorption peak attributed to an Si-CH₂ group was observed at 825 cm⁻¹ and 739 cm⁻¹ in the same manner as in Example 1. It was thus confirmed that the resin composition [E3] contained a silane-modified polymer. An extruded sheet [SE3] and a vacuum press-molded specimen were prepared in the same manner as in Example 1 using the solar cell element encapsulating material [E3], and the light transmittance, the water vapor permeability, the tensile strength, the tensile elongation, the volume resistivity, the initial adhesion to a glass substrate, the adhesion to a glass substrate after being subjected to a high-temperature/high-humidity environment, the corrosion resistance and the weatherability of the encapsulated copper sheet, and the durability of the solar cell module were evaluated as described above. The results are shown in Table 1.

### Comparative Example 3

### Solar cell element encapsulating material [F3] and sheet [SF3]

2.0 parts of vinyltrimethoxysilane and 0.2 parts of di-t-butyl peroxide were added to 100 parts of the pellets of the resin composition [F2] obtained in Reference Example 6. The mixture was kneaded in the same manner as in Example 1 to obtain 95 parts of pellets of a solar cell element encapsulating material [F3].

The FT-IR spectrum of the resulting pellets was measured. An absorption peak attributed to an Si-OCH₃ group was observed at 1090 cm⁻¹, and an absorption peak attributed to an Si-CH₂ group was observed at 825 cm⁻¹ and 739 cm⁻¹ in the same manner as in Example 1. It was thus confirmed that the solar cell element encapsulating material [F3] contained a silane-modified polymer.

An extruded sheet [SF3] and a vacuum press-molded specimen were prepared in the same manner as in Example 1 using the solar cell element encapsulating material [F3], and the light transmittance, the water vapor permeability, the tensile strength, the tensile elongation, the volume resistivity, the initial adhesion to a glass substrate, the adhesion to a glass substrate after being subjected to a high-temperature/high-humidity environment, the corrosion resistance and the weatherability of the encapsulated copper sheet, and the durability of the solar cell module were evaluated as described above. The results are shown in Table 1.

### Comparative Example 4

### Hydrogenated block copolymer resin composition[A2] and sheet [SA2]

An extruded sheet [SA2] and a vacuum press-molded specimen were prepared in the same manner as in Example 1, except that the pellets of the resin composition [A2] obtained in Reference Example 1 were used instead of the pellets of the solar cell element encapsulating material [A3], and the light transmittance, the water vapor permeability, the tensile strength, the tensile elongation, the volume resistivity, the initial adhesion to a glass substrate, the adhesion to a glass substrate after being subjected to a high-temperature/high-humidity environment, the corrosion resistance and the weatherability of the encapsulated copper sheet, and the durability of the solar cell module were evaluated as described above. The results are shown in Table 1.

**TABLE 1**

| | | | | Example | | | | | Comparative Example | | | |
|---|---|---|---|---|---|---|---|---|---|---|---|---|
| | | | | 1 | 2 | 3 | 4 | 5 | 1 | 2 | 3 | 4 |
| Solar cell element encapsulating material | | | | A3 | A3/A2 | B3 | C3 | D3 | EVA2 | E3 | F3 | A2 |
| Layer configuration | | | | Single layer | 3-material/ 3-layer | Single layer | Single layer | Single layer | Single layer | Single layer | Single layer | Single layer |
| Properties/ test results | Light transmittance | | % | 90 | 91 | 90 | 90 | 90 | 90 | 90 | 90 | 91 |
| | Water vapor permeability | | g/cm²·day | 1.3 | 1.3 | 2.1 | 1.8 | 1.4 | 47 | 3.0 | 1.3 | 1.3 |
| | Tensile strength | | MPa | 34 | 38 | 26 | 31 | 32 | 25 | 20 | 45 | 38 |
| | Tensile elongation | | % | 550 | 550 | 650 | 600 | 600 | 530 | >700 | 5 | 550 |
| | Volume resistivity | | Ω·cm | 1.5 × 10¹⁶ | 2 × 10¹⁶ | 1.5 × 10¹⁶ | 1.5 × 10¹⁶ | 1.5 × 10¹⁶ | 8 × 10¹⁶ | 1 × 10¹⁶ | 1.5 × 10¹⁶ | 2 × 10¹⁶ |
| | Peeling | Initial | N/cm | >20 | >20 | >20 | >20 | >20 | >20 | >20 | 15 | 10 |
| | strength | After 1000 hr | N/cm | >20 | >20 | >20 | >20 | >20 | >20 | >20 | <2 | <2 |
| | Workability (light transmittance) | | % | 86 | 88 | 86 | 86 | 85 | 89 | 85 | 86 | 88 |
| | Corrosion resistance | | Appearance | Transparent | Transparent | Transparent | Transparent | Transparent | Transparent | Transparent | Transparent | Transparent |
| | | | Odor | No | No | No | No | No | Yes | No | No | No |
| | | | Dicoloration | No | No | No | No | No | Yes | No | No | No |
| | Durability | | -- | Acceptable | Acceptable | Acceptable | Acceptable | Acceptable | Acceptable | Deformed | Cracks occurred | Acceptable |

As shown in Table I, the following items were confirmed.

Specifically, when using the solar cell element encapsulating material according to one embodiment of the invention, excellent light transmittance, water vapor permeability, mechanical strength, flexibility, electrical insulating properties, adhesion to glass after being subjected to a high-temperature/high-humidity environment, and weatherability were achieved, and the solar cell module exhibited excellent durability (Examples 1 to 5).

In contrast, when using the EVA-containing encapsulating material, the internal wire may be corroded during storage in a high-temperature/high-humidity environment for a long time due to a high water vapor permeability and generation of acetic acid via hydrolysis (Comparative Example 1).

When the content of the polymer block [A] containing the repeating unit derived from the aromatic vinyl compound as the main component was low, the heat resistance was low, and the solar cell module exhibited low durability (Comparative Example 2).

When the content of the polymer block [A] containing the repeating unit derived from the aromatic vinyl compound as the main component was high, the resin composition exhibited low adhesion to glass, and the solar cell module exhibited low durability (Comparative Example 3).

When using the hydrogenated block copolymer that was not modified with a silane, a decrease in adhesion to glass occurred after exposure to a high-temperature/high-humidity environment (Comparative Example 4).

### Synthesis Example 1

### Synthesis of hydrogenated block copolymer resin composition (a)

0.1 parts of the hindered amine light stabilizer and 0.1 parts of the benzotriazole UV absorber used in Reference Example 1 were added to 100 parts of the pellets of the hydrogenated block copolymer [Al] obtained in Reference Example 1, The mixture was kneaded at a resin temperature of 250°C using a twin-screw kneader ("TEM-35B" manufactured by Toshiba Machine Co., Ltd.), extruded in the shape of a strand, cooled with water, and cut using a pelletizer to obtain 98 parts of pellets of a hydrogenated block copolymer resin composition (a) (hereinafter referred to as "resin composition (a)").

### Synthesis Example 2

### Synthesis of hydrogenated block copolymer resin composition (b)

0.1 parts of the hindered amine light stabilizer and 0.1 parts of the benzotriazole UV absorber used in Reference Example 3 were added to 100 parts of the pellets of the hydrogenated block copolymer [Cl] obtained in Reference Example 3, and the components were kneaded to obtain 96 parts of pellets of a hydrogenated block copolymer resin composition (b) (hereinafter referred to as "resin composition (b)").

### Example 6

### Alkoxysilylated polymer (i-a) and sheet [I-a]

2.0 parts of vinyltrimethoxysilane and 0.2 parts of di-t-butyl peroxide were added to 100 parts of the pellets of the resin composition (a) obtained in Synthesis Example 1. The mixture was kneaded at a resin temperature of 210°C for a residence time of 80 to 90 seconds using a twin-screw extruder ("TEM-37B" manufactured by Toshiba Machine Co., Ltd.), extruded in the shape of a strand, cooled with air, and cut using a pelletizer to obtain 97 parts of pellets of an alkoxysilylated polymer (i-a).

After dissolving 10 parts of the pellets of the alkoxysilylated polymer (i-a) in 100 parts of cyclohexane, the solution was poured into 400 parts of dehydrated acetone to coagulate the alkoxysilylated (modified) polymer. The alkoxysilylated polymer was filtered off, and dried at 25°C under vacuum to isolate 9.5 parts of the alkoxysilylated polymer.

The FT-IR spectrum of the resulting alkoxysilylated polymer was measured. An absorption peak attributed to an Si-OCH₃ group was observed at 1090 cm⁻¹, and an absorption peak attributed to an Si-CH₂ group was observed at 825 cm⁻¹ and 739 cm⁻¹. These absorption peaks differ from those (1075 cm⁻¹, 808 cm⁻¹, 766 cm⁻¹) of vinyltrimethoxysilane. 0.3% of Si was detected as a result of subjecting the alkoxysilylated polymer to elemental analysis. It was thus confirmed that the alkoxysilylated polymer (i-a) contained a methoxysilyl group.

### Extrusion molding

The pellets of the alkoxysilylated (modified) polymer (i-a) were heated at 50°C for 4 hours using a hot-blast dryer to remove dissolved air. The alkoxysilylated polymer (i-a) was extrusion-molded from resin melt extruders (screw diameter: 25 mm) of a T die film melt extrusion molding machine (T-die width: 300 mm) at a molten resin temperature of 200°C, a T-die temperature of 200°C, and a roll temperature of 50°C to obtain extruded sheets (I-a₄₀₀, I-a₁₇₀, and I-a₁₄₀) having a thickness of 400, 170, or 140 µm and a width of 280 mm. The resulting extruded sheet was wound around a roll.

### Example 7

### Alkoxysilylated polymer (i-b) and sheet [I-b]

2.0 parts of vinyltrimethoxysilane and 0.2 parts of di-t-butyl peroxide were added to 100 parts of the pellets of the resin composition (b) obtained in Synthesis Example 2, and 97 parts of pellets of an alkoxysilylated (modified) polymer (i-b) were obtained in the same manner as in Example 6.

The FT-IR spectrum of the pellets of the alkoxysilylated polymer (i-b) was measured. An absorption peak attributed to an Si-OCH₃ group was observed at 1090 cm⁻¹, and an absorption peak attributed to an Si-CH₂ group was observed at 825 cm⁻¹ and 739 cm⁻¹. 0.3% of Si was detected as a result of subjecting the alkoxysilylated polymer (i-b) to elemental analysis. It was thus confirmed that the alkoxysilylated polymer (i-b) contained a methoxysilyl group.

### Extrusion molding

The pellets of the alkoxysilylated polymer (i-b) were extrusion-molded in the same manner as in Example 6 to obtain extruded sheets (I-b₄₀₀, I-b₁₇₀, and I-b₁₄₀) having a thickness of 400, 170, or 140 µm and a width of 280 mm. The resulting extruded sheet was wound around a roll.

### Reference Example 7

### Alkoxysilylated polyolefin (ii-a) and sheet [II-a]

1.5 parts of vinyltrimethoxysilane and 0.15 parts of 2,5-dimethyl-2,5-di(t-butylperoxy)hexane were added to 100 parts of pellets of a commercially available ethylene-octene copolymer ("Affinity (registered trademark) PL1880" manufactured by Dow Chemical Japan Ltd., melting point: 100°C). The mixture was kneaded in the same manner as in Reference Example 7 at a resin temperature of 180°C for a residence time of 90 to 120 seconds to obtain 90 parts of pellets of an alkoxysilylated polyolefin (ii-a).

The pellets of the alkoxysilylated polyolefin (ii-a) were press-molded at 140°C to obtain a film having a thickness of 30 to 100 µm.

The FT-IR spectrum of the resulting film was measured. An absorption peak attributed to an Si-OCH₃ group was observed at 1090 cm⁻¹, and an absorption peak attributed to an Si-CH₂ groups was observed at 825 cm⁻¹ and 739 cm⁻¹. These absorption peaks differ from those (1075 cm⁻¹ 808 cm⁻¹, 766 cm⁻¹) of vinyltrimethoxysilane. 0.3% of Si was detected as a result of subjecting the film to elemental analysis. It was thus confirmed that the alkoxysilylated polyolefin (ii-a) contained a methoxysilyl group.

### Extrusion molding

The pellets of the alkoxysilylated polyolefin (ii-a) were extrusion-molded in the same manner as in Reference Example 7 at a molten resin temperature of 190°C, a T-die temperature of 190°C, and a roll temperature of 50°C to obtain extruded sheets (II-a₁₂₀ and II-a₆₀) having a thickness of 120 or 60 µm and a width of 280 mm. The resulting extruded sheet was wound around a roll.

### Reference Example 8

### Alkoxysilylated polyolefin (ii-b) and sheet [II-b]

2.0 parts of vinyltrimethoxysilane and 0.2 parts of 2,5-dimethyl-2,5-di(t-butylperoxy)hexane were added to 100 parts of pellets of a commercially available LLDPE ("Umerit (registered trademark) 20B" manufactured by Ube-Maruzen Polyethylene Co., Ltd., melting point: 119°C).

The mixture was kneaded in the same manner as in Example 6 at a resin temperature of 200°C for a residence time of 80 to 90 seconds to obtain 95 parts of pellets of an alkoxysilylated polyolefin (ii-b).

The pellets of the alkoxysilylated polyolefin (ii-b) were press-molded at 160°C to obtain a film having a thickness of 30 to 100 µm.

The FT-IR spectrum of the resulting film was measured. An absorption peak attributed to an Si-OCH₃ group was observed at 1090 cm⁻¹, and an absorption peak attributed to an Si-CH₂ group was observed at 825 cm⁻¹ and 739 cm⁻¹. These absorption peaks differ from those (1075 cm⁻¹, 808 cm⁻¹, 766 cm⁻¹) of vinyltrimethoxysilane, 0.3% of Si was detected as a result of subjecting the film to elemental analysis. It was thus confirmed that the alkoxysilylated polyolefin (ii-b) contained a methoxysilyl group.

### Extrusion molding

The pellets of the alkoxysilylated polyolefin (ii-b) were extrusion-molded in the same manner as in Reference Example 7 at a molten resin temperature of 210°C, a T-die temperature of 210°C, and a roll temperature of 70°C to obtain an extruded sheet (II-b₆₀) having a thickness of 60 µm and a width of 280 mm. The resulting extruded sheet was wound around a roll.

### Example 8

### Multilayer sheet [I-a]/[II-a]/[I-a] and evaluation of multilayer sheet [I-a]/[II-a]/[I-a] as solar cell element encapsulating material

The extruded sheet I-a₁₇₀ obtained in Example 6 and the extruded sheet II-a₆₀ obtained in Reference Example 9 were cut to dimensions of 220×220 mm. The resulting sheets were stacked in order of "I-a₁₇₀/II-a₆₀/I-a₁₇₀", degassed at 110°C for 1 minute under vacuum using the vacuum laminator, and vacuum-pressed for 1 minute to obtain a two-material/three-layer multilayer sheet [I-a₁₇₀]/[LII-a₆₀]/[I-a₁₇₀] having a thickness of 0.4 mm.

A test sheet was prepared using the multilayer sheet, and (3) the light transmittance, (4) the water vapor permeability, (5) the tensile modulus, tensile strength, and tensile elongation, (6) the volume resistivity, (7) adhesion to the glass substrate (peeling strength), (8) weatherability, (9) the corrosion resistance of the encapsulated copper sheet, and (11) the presence or absence of cracks in the cells during production of the solar cell module, and the durability of the solar cell module were evaluated.

The results are shown in Tables 2 and 3.

### Example 9

### Multilayer sheet [I-a]/[II-a]/[I-a] and evaluation of multilayer sheet [I-a]/[II-a]/[I-a] as solar cell element encapsulating material

The extruded sheet I-a₁₄₀ obtained in Example 6 and the extruded sheet II-a₁₂₀ obtained in Reference Example 9 were cut to dimensions of 220x220 mm. The resulting sheets were stacked in order of "I-a₁₄₀/II-a₁₂₀/I-a₁₄₀", degassed at 110°C for 1 minute under vacuum using the vacuum laminator, and vacuum-pressed for 1 minute to obtain a two-material/three-layer multilayer sheet [I-a₁₄₀]/[II-a₁₂₀]/[I-a₁₄₀] having a thickness of 0.4 mm.

A test sheet was prepared using the multilayer sheet, and each item was evaluated in the same manner as in Example 6. The results are shown in Tables 2 and 3.

### Example 10

### Multilayer sheet [I-b]/[II-a]/[I-b] and evaluation of multilayer sheet [I-b]/[II-a]/[I-b] as solar cell element encapsulating material

The extruded sheet I-b₁₇₀ obtained in Example 7 and the extruded sheet II-a₆₀ obtained in Reference Example 9 were cut to dimensions of 220×220 mm. The resulting sheets were stacked in order of "I-b₁₇₀/II-a₆₀/I-b₁₇₀", degassed at 110°C for 1 minute under vacuum using the vacuum laminator, and vacuum-pressed for 1 minute to obtain a two-material/three-layer multilayer sheet [I-b₁₇₀]/[II-a₆₀]/[I-b₁₇₀] having a thickness of 0.4 mm.

A test sheet was prepared using the multilayer sheet, and each item was evaluated in the same manner as in Example 6. The results are shown in Table 2.

### Example 11

### Multilayer sheet [I-b]/[II-a]/[I-b] and evaluation of multilayer sheet [I-b]/[II-a]/[I-b] as solar cell element encapsulating material

The extruded sheet I-b₁₄₀ obtained in Example 7 and the extruded sheet II-a₁₂₀ obtained in Reference Example 9 were cut to dimensions of 220×220 mm. The resulting sheets were stacked in order of "I-b₁₄₀/II-a₁₂₀/I-b₁₄₀", degassed at 110°C for 1 minute under vacuum using the vacuum laminator, and vacuum-pressed for 1 minute to obtain a two-material/three-layer multilayer sheet [I-b₁₄₀]/[II-a₁₂₀]/[I-b₁₄₀] having a thickness of 0.4 mm.

A test sheet was prepared using the multilayer sheet, and each item was evaluated in the same manner as in Example 6. The results are shown in Tables 2 and 3.

### Example 12

### Multilayer sheet [I-a]/[II-b]/[I-a] and evaluation of multilayer sheet [I-a]/[II-b]/[I-a] as solar cell element encapsulating material

The extruded sheet I-a₁₇₀ obtained in Example 6 and the extruded sheet II-b₆₀ obtained in Reference Example 10 were cut to dimensions of 220×220 mm. The resulting sheets were stacked in order of "I-a₁₇₀/II-b₆₀/I-a₁₇₀", degassed at 130°C for 1 minute under vacuum using the vacuum laminator, and vacuum-pressed for 1 minute to obtain a two-material/three-layer multilayer sheet [I-a₁₇₀]/[II-b₆₀]/[I-a₁₇₀] having a thickness of 0.4 mm.

A test sheet was prepared using the multilayer sheet, and each item was evaluated in the same manner as in Example 6. The results are shown in Tables 2 and 3.

### Example 13

### Multilayer sheet [I-b]/[II-b]/[I-b] and evaluation of multilayer sheet [I-b]/[II-b]/[I-b] as solar cell element encapsulating material

The extruded sheet I-b₁₇₀ obtained in Example 7 and the extruded sheet II-b₆₀ obtained in Reference Example 10 were cut to dimensions of 220×220 mm. The resulting sheets were stacked in order of "I-b₁₇₀/II-b₆₀/I-b₁₇₀", degassed at 130°C for 1 minute under vacuum using the vacuum laminator, and vacuum-pressed for 1 minute to obtain a two-material/three-layer multilayer sheet [I-b₁₇₀]/[II-b₆₀]/[I-b₁₇₀] having a thickness of 0.4 mm.

A test sheet was prepared using the multilayer sheet, and each item was evaluated in the same manner as in Example 8. The results are shown in Tables 2 and 3.

**TABLE 2**

| | | | | Example 8 (multilayer sheet) | Example 9 (multilayer sheet) | Example 10 (multilayer sheet) | Example 11 (multilayer sheet) | Example 12 (multilayer sheet) | Example 13 (multilayer sheet) |
|---|---|---|---|---|---|---|---|---|---|
| Properties/test results of encapsulating material sheet | Layer configuration of encapsulating material | | Layer 1 | I-a170 | I-a140 | I-b170 | I-b140 | I-a170 | I-b170 |
| | | | Layer 2 | II-a60 | II-a120 | II-a60 | II-a120 | II-b60 | II-b60 |
| | | | Layer 3 | I-a170 | I-a140 | I-b170 | I-b140 | I-a170 | I-b170 |
| | Light transmittance | | % | 93 | 89 | 90 | 89 | 89 | 89 |
| | Water vapor permeability (thickness 400 µm) | | g/(m² · day) | 1.0 | 1.1 | 1.0 | 1.1 | 1.0 | 1.0 |
| | Tensile strength (fracture point) | | MPa | 38 | 40 | 34 | 38 | 38 | 36 |
| | Tensile elongation | | % | 550 | 500 | 600 | 580 | 890 | 650 |
| | Volume resistivity | | Ω · cm | 1.5 × 10¹⁶ | 1.5 × 10¹⁶ | 1.5 × 10¹⁶ | 1.5 × 10¹⁶ | 2.0 × 10¹⁶ | 2.0 × 10¹⁶ |
| | Peeling | Initial | N/cm | >20 | >20 | >20 | >20 | >20 | >20 |
| | strength | 85° C., 85% RH, after 200 hours | N/cm | >20 | >20 | >20 | >20 | >20 | >20 |
| | Light transmittance after workability test | | % | 89 | 88 | 89 | 88 | 88 | 88 |
| | Corrosion resistance of encapsulated copper sheet | | Appearance | Transparent | Transparent | Transparent | Transparent | Transparent | Transparent |
| | | | Odor | No | No | No | No | No | No |
| | | | Dicoloration of copper sheet | No | No | No | No | No | No |

**TABLE 3**

| | | | Example 8 (multilayer sheet) | Example 9 (multilayer sheet) | Example 10 (multilayer sheet) | Example 11 (multilayer sheet) | Example 12 (multilayer sheet) | Example 13 (multilayer sheet) |
|---|---|---|---|---|---|---|---|---|
| | Glass | | | | | | | |
| Layer configuration when producing solar cell module | Layer configuration of encapsulating material | Layer 1 | I-a170 | I-a140 | I-b170 | I-b140 | I-a170 | I-b170 |
| | | Layer 2 | II-a60 | II-a120 | II-a60 | II-a120 | II-b60 | II-b60 |
| | | Layer 3 | I-a170 | I-a140 | I-n170 | I-b140 | I-a170 | I-b170 |
| | Solar cell element | | | | | | | |
| | Layer configuration of encapsulating material | Layer 1 | I-a170 | I-a140 | I-n170 | I-b140 | I-a170 | I-b170 |
| | | Layer 2 | II-a60 | II-a120 | II-a60 | II-a120 | II-b60 | II-b60 |
| | | Layer 3 | I-a170 | I-a140 | I-n170 | I-b140 | I-a170 | I-b170 |
| | Backsheet | | | | | | | |
| Cracks in cells when producing solar cell module | Vacuum lamination temperature | 145° C. | 1/5 | Acceptable | Acceptable | Acceptable | 2/5 | Acceptable |
| | | 150° C. | Acceptable | Acceptable | Acceptable | Acceptable | Acceptable | Acceptable |
| | | 155° C. | Acceptable | Acceptable | Acceptable | Acceptable | Acceptable | Acceptable |
| | | 160° C. | Acceptable | Acceptable | Acceptable | Acceptable | Acceptable | Acceptable |
| | | 165° C. | Acceptable | Acceptable | Acceptable | Acceptable | Acceptable | Acceptable |

As shown in Tables 2 and 3, the following items were confirmed.

The multilayer sheet prepared using the silane-modified hydrogenated block copolymer (alkoxysilylated polymer) and the silane-modified polyolefin (alkoxysilylated polyolefin) (Examples 8 to 13) exhibited low hygroscopicity, non-hydrolyzability, weatherability, and transparency, maintained excellent adhesion to glass even when exposed to a high-temperature/high-humidity environment for a long time, and could encapsulate the solar cell element without applying a special waterproof treatment. Moreover, cracks in the cells rarely occurred even when the polycrystalline silicon solar cell was encapsulated at 145 to 160°C (i.e., the polycrystalline silicon solar cell can be encapsulated at a lower temperature).

### INDUSTRIAL APPLICABILITY

The solar cell element encapsulating material, the sheet, and the multilayer sheet according to the embodiments of the invention may suitably be used to encapsulate a solar cell element.

### REFERENCE SIGNS LIST

- 1: Transparent front substrate
- 2: Solar cell element
- 3: Encapsulating material
- 4: Tab wire
- 5: Backsheet

## Claims

1. An alkoxysilyl group-containing hydrogenated block copolymer obtainable by introducing an alkoxysilyl group into a hydrogenated block copolymer that is obtained by hydrogenating 90% or more of the carbon-carbon unsaturated bonds of the main chain, the side chain, and the aromatic ring of a block copolymer that comprises at least two polymer blocks [A] and at least one polymer block [B], the polymer block [A] including a repeating unit derived from an aromatic vinyl compound as a main component, the polymer block [B] including a repeating unit derived from a linear conjugated diene compound as a main component, and a ratio (wA:wB) of a weight fraction wA of the polymer block [A] in the block copolymer to a weight fraction wB of the polymer block [B] in the block copolymer being 20:80 to 60:40.

2. An alkoxysilyl group-containing hydrogenated block copolymer according to claim 1 obtainable by introducing an alkoxysilyl group into a hydrogenated block copolymer that is obtained by hydrogenating 90% or more of the carbon-carbon unsaturated bonds of the main chain, the side chain, and the aromatic ring of a block copolyner that comprises at least two polymer blocks [A] and at least one polymer block [B], the polymer block [A] including a repeating unit derived from an aromatic vinyl compound as a main component, the polymer block [B] including a repeating unit derived from a linear conjugated diene compound as a main component, and a ratio (wA:wB) of a weight fraction wA of the polymer block [A] in the block copolymer to a weight fraction wB of the polymer block [B] in the block copolymer being 40:60 to 60:40.

3. A method for producing the alkoxysilyl group-containing hydrogenated block copolymer according to claim 1, the method comprising reacting an ethylenically unsaturated silane compound with a hydrogenated block copolymer in the presence of an organic peroxide, the hydrogenated block copolymer being obtained by hydrogenating 90% or more of the carbon-carbon unsaturated bonds of the main chain, the side chain, and the aromatic ring of a block copolymer that comprises at least two polymer blocks [A] and at least one polymer block [B], the polymer block [A] including a repeating unit derived from an aromatic vinyl compound as a main component, the polymer block [B] including a repeating unit derived from a linear conjugated diene compound as a main component, and a ratio (wA:wB) of a weight fraction wA of the polymer block [A] in the block copolymer to a weight fraction wB of the polymer block [B] in the block copolymer being 20:80 to 60:40.

4. The method according to claim 3, wherein the ethylenically unsaturated silane compound is at least one ethylenically unsaturated silane compound selected from a group consisting of vinyltrimethoxysilane, vinyltriethoxysilane, allyltrimethoxysilane, allyltriethoxysilane, dimethoxymethylvinylsilane, diethoxymethylvinylsilane, p-styryltrimethoxysilane, and p-styryltriethoxysilane.

5. A solar cell element encapsulating material comprising the alkoxysilyl group-containing hydrogenated block copolymer according to claim 1 or 2.

6. The solar cell element encapsulating material according to claim 5, further comprising a hindered amine light stabilizer in an amount of 0.1 to 10 parts by weight based on 100 parts by weight of the alkoxysilyl group-containing hydrogenated block copolymer.

7. The solar cell element encapsulating material according to claim 5, further comprising a UV absorber in an amount of 0.01 to 0.1 parts by weight based on 100 parts by weight of the alkoxysilyl group-containing hydrogenated block copolymer.

8. The solar cell element encapsulating material according to claim 5, further comprising a phosphorus-based antioxidant in an amount of 0.01 to 0.1 parts by weight based on 100 parts by weight of the alkoxysilyl group-containing hydrogenated block copolymer.

9. A sheet comprising the solar cell element encapsulating material according to any one of claims 5 to 8.

10. A laminated sheet comprising a sheet that is formed of a resin composition, and the sheet according to claim 9 that is stacked on one side or each side of the sheet that is formed of the resin composition, the resin composition including (α) a hydrogenated block copolymer, and (β) at least one component selected from a group consisting of a polymer other than the hydrogenated block copolymer (α) that includes an alkoxysilyl group, a light stabilizer, a UV absorber, and an antioxidant, the hydrogenated block copolymer being obtained by hydrogenating 90% or more of the carbon-carbon unsaturated bonds of the main chain, the side chain, and the aromatic ring of a block copolymer that includes at least two polymer blocks [A] and at least one polymer block [B], the polymer block [A] including a repeating unit derived from an aromatic vinyl compound as a main component, the polymer block [B] including a repeating unit derived from a linear conjugated diene compound as a main component, and a ratio (wA:wB) of a weight fraction wA of the polymer block [A] in the block copolymer to a weight fraction wB of the polymer block [B] in the block copolymer being 20:80 to 60:40.

11. A multilayer sheet comprising [I] a layer that includes an alkoxysilyl group-containing hydrogenated block copolymer (i), and [II] a layer that includes a (co)polymer (ii) that is obtained by introducing an alkoxysilyl group into a (co)polymer that has a melting point of 90 to 140 °C and is obtained by polymerizing ethylene and/or an α-olefin having 3 to 10 carbon atoms, the alkoxysilyl group-containing hydrogenated block copolymer (i) being obtainable by introducing an alkoxysilyl group into a hydrogenated block copolymer that is obtained by hydrogenating 90% or more of the carbon-carbon unsaturated bonds of the main chain, the side chain, and the aromatic ring of a block copolymer that comprises at least two polymer blocks [A] and at least one polymer block [B], the polymer block [A] including a repeating unit derived from an aromatic vinyl compound as a main component, the polymer block [B] including a repeating unit derived from a linear conjugated diene compound as a main component, and a ratio (wA:wB) of a weight fraction wA of the polymer block [A] in the block copolymer to a weight fraction wB of the polymer block [B] in the block copolymer being 40:60 to 60:40.

12. The multilayer sheet according to claim 11, wherein the layer [I] is formed of a layer-forming material that includes the alkoxysilyl group-containing hydrogenated block copolymer (i), and a hindered amine light stabilizer in an amount of 0.1 to 5 parts by weight based on 100 parts by weight of the alkoxysilyl group-containing hydrogenated block copolymer (i), and/or the layer [II] is formed of a layer-forming material that includes the (co)polymer (ii), and a hindered amine light stabilizer in an amount of 0.1 to 5 parts by weight based on 100 parts by weight of the (co)polymer (ii).

13. The multilayer sheet according to claim 11, wherein the layer [I] is formed of a layer-forming material that includes the alkoxysilyl group-containing hydrogenated block copolymer (i), and a UV absorber in an amount of 0.01 to 0.2 parts by weight based on 100 parts by weight of the alkoxysilyl group-containing hydrogenated block copolymer (i), and/or the layer [II] is formed of a layer-forming material that includes the (co)polymer (ii), and a UV absorber in an amount of 0.01 to 0.2 parts by weight based on 100 parts by weight of the (co)polymer (ii).

14. The multilayer sheet according to claim 11, the multilayer sheet having a layer configuration that includes the layer [I] and the layer [II], or a layer configuration that sequentially includes the layer [I], the layer [II], and the layer [I].

15. A method for encapsulating a solar cell element comprising disposing the multilayer sheet according to claim 14 so that the layer [I] of the multilayer sheet comes in contact with a crystalline solar cell.

## Patentansprüche

1. Ein Alkoxysilylgruppen-enthaltendes hydriertes Blockcopolymer, das erhältlich ist durch Einführen einer Alkoxysilylgruppe in ein hydriertes Blockcopolymer, das erhältlich ist durch Hydrieren von 90% oder mehr der Kohlenstoff-Kohlenstoff ungesättigten Bindungen der Hauptkette, der Seitenkette und des aromatischen Rings eines Blockcopolymers, das mindestens zwei Polymerblöcke [A] und mindestens einen Polymerblock [B] umfasst, wobei der Polymerblock [A] eine Wiederholungseinheit, die von einer aromatischen Vinylverbindung abgeleitet ist, als Hauptkomponente enthält, der Polymerblock [B] eine Wiederholungseinheit, die von einer linearen konjugierten Dienverbindung abgeleitet ist, als Hauptkomponente enthält, und ein Verhältnis (wA:wB) eines Gewichtsanteils wA des Polymerblocks [A] in dem Blockcopolymer zu einem Gewichtsanteil wB des Polymerblocks [B] in dem Blockcopolymer 20:80 bis 60:40 beträgt.

2. Ein Alkoxysilylgruppen-enthaltendes hydriertes Blockcopolymer gemäß Anspruch 1, das erhältlich ist durch Einführen einer Alkoxysilylgruppe in ein hydriertes Blockcopolymer, das erhältlich ist durch Hydrieren von 90% oder mehr der Kohlenstoff-Kohlenstoff ungesättigten Bindungen der Hauptkette, der Seitenkette und des aromatischen Rings eines Blockcopolymers, das mindestens zwei Polymerblöcke [A] und mindestens einen Polymerblock [B] umfasst, wobei der Polymerblock [A] eine Wiederholungseinheit, die von einer aromatischen Vinylverbindung abgeleitet ist, als Hauptkomponente enthält, der Polymerblock [B] eine Wiederholungseinheit, die von einer linearen konjugierten Dienverbindung abgeleitet ist, als Hauptkomponente enthält, und ein Verhältnis (wA:wB) eines Gewichtsanteils wA des Polymerblocks [A] in dem Blockcopolymer zu einem Gewichtsanteil wB des Polymerblocks [B] in dem Blockcopolymer 40:60 bis 60:40 beträgt.

3. Ein Verfahren zur Herstellung des Alkoxysilylgruppen-enthaltenden hydrierten Blockcopolymers gemäß Anspruch 1, wobei das Verfahren die Umsetzung einer ethylenisch ungesättigten Silanverbindung mit einem hydrierten Blockcopolymer in der Gegenwart eines organischen Peroxids umfasst, wobei das hydrierte Blockcopolymer erhalten wird durch Hydrieren von 90% oder mehr der Kohlenstoff-Kohlenstoff ungesättigten Bindungen der Hauptkette, der Seitenkette und des aromatischen Rings eines Blockcopolymers, das mindestens zwei Polymerblöcke [A] und mindestens einen Polymerblock [B] umfasst, wobei der Polymerblock [A] eine Wiederholungseinheit, die von einer aromatischen Vinylverbindung abgeleitet ist, als Hauptkomponente enthält, der Polymerblock [B] eine Wiederholungseinheit, die von einer linearen konjugierten Dienverbindung abgeleitet ist, als Hauptkomponente enthält, und ein Verhältnis (wA:wB) eines Gewichtsanteils wA des Polymerblocks [A] in dem Blockcopolymer zu einem Gewichtsanteil wB des Polymerblocks [B] in dem Blockcopolymer 20:80 bis 60:40 beträgt.

4. Das Verfahren gemäß Anspruch 3, wobei die ethylenisch ungesättigte Silanverbindung mindestens eine ethylenisch ungesättigte Silanverbindung, ausgewählt aus einer Gruppe bestehend aus Vinyltrimethoxysilan, Vinyltriethoxysilan, Allyltrimethoxysilan, Allyltriethoxysilan, Dimethoxymethylvinylsilan, Diethoxymethylvinylsilan, p-Styryltrimethoxysilan und p-Styryltriethoxysilan, ist.

5. Ein Solarzellenelement-einschließendes Material, das das Alkoxysilylgruppen-enthaltende hydrierte Blockcopolymer gemäß Anspruch 1 oder 2 umfasst.

6. Das Solarzellenelement-einschließende Material gemäß Anspruch 5, das darüber hinaus einen Lichtstabilisator vom Typ eines gehinderten Amins in einer Menge von 0,1 bis 10 Gewichtsteilen, bezogen auf 100 Gewichtsteile des Alkoxysilylgruppen-enthaltenden hydrierten Blockcopolymers, umfasst.

7. Das Solarzellenelement-einschließende Material gemäß Anspruch 5, das darüber hinaus einen UV-Absorber in einer Menge von 0,01 bis 0,1 Gewichtsteilen, bezogen auf 100 Gewichtsteile des Alkoxysilylgruppen-enthaltenden hydrierten Blockcopolymers, umfasst.

8. Das Solarzellenelement-einschließende Material gemäß Anspruch 5, das darüber hinaus ein Antioxidans auf Phosphorbasis in einer Menge von 0,01 bis 0,1 Gewichtsteilen, bezogen auf 100 Gewichtsteile des Alkoxysilylgruppen-enthaltenden hydrierten Blockcopolymers, umfasst.

9. Ein Blatt, das das Solarzellenelement-einschließende Material gemäß einem der Ansprüche 5 bis 8 umfasst.

10. Ein laminiertes Blatt, das ein Blatt, das aus einer Harzzusammensetzung gebildet ist, und das Blatt gemäß Anspruch 9 umfasst, das auf einer Seite oder jeder Seite des Blatts, das aus der Harzzusammensetzung gebildet ist, geschichtet ist, wobei die Harzzusammensetzung (α) ein hydriertes Blockcopolymer, und (β) mindestens eine Komponente, ausgewählt aus einer Gruppe bestehend aus einem von dem hydrierten Blockcopolymer (α) verschiedenen Polymer umfasst, das eine Alkoxysilylgruppe, einen Lichtstabilisator, einen UV-Absorber und ein Antioxidans umfasst, wobei das hydrierte Blockcopolymer erhalten ist durch Hydrieren von 90% oder mehr der Kohlenstoff-Kohlenstoff ungesättigten Bindungen der Hauptkette, der Seitenkette, und des aromatischen Rings eines Blockcopolymers, das mindestens zwei Polymerblöcke [A] und mindestens einen Polymerblock [B] umfasst, wobei der Polymerblock [A] eine Wiederholungseinheit, die von einer aromatischen Vinylverbindung abgeleitet ist, als Hauptkomponente enthält, der Polymerblock [B] eine Wiederholungseinheit, die von einer linearen konjugierten Dienverbindung abgeleitet ist, als Hauptkomponente enthält, und ein Verhältnis (wA:wB) eines Gewichtsanteils wA des Polymerblocks [A] in dem Blockcopolymer zu einem Gewichtsanteil wB des Polymerblocks [B] in dem Blockcopolymer 20:80 bis 60:40 beträgt.

11. Ein mehrschichtiges Blatt, das [I] eine Schicht, die ein Alkoxysilylgruppen-enthaltendes hydriertes Blockcopolymer (i) enthält, und [II] eine Schicht, die ein (Co)Polymer (ii), das durch Einführen einer Alkoxysilylgruppe in ein (Co)Polymer erhalten ist, das einen Schmelzpunkt von 90 bis 140 °C aufweist und durch Polymerisieren von Ethylen und/oder einem α-Olefin mit 3 bis 10 Kohlenstoffatomen erhalten ist, umfasst, wobei das Alkoxysilylgruppen-enthaltende hydrierte Blockcopolymer (i) erhältlich ist durch Einführen einer Alkoxysilylgruppe in ein hydriertes Blockcopolymer, das erhalten ist durch Hydrieren von 90% oder mehr der Kohlenstoff-Kohlenstoff ungesättigten Bindungen der Hauptkette, der Seitenkette und des aromatischen Rings eines Blockcopolymers, das mindestens zwei Polymerblöcke [A] und mindestens einen Polymerblock [B] umfasst, wobei der Polymerblock [A] eine Wiederholungseinheit, die von einer aromatischen Vinylverbindung abgeleitet ist, als Hauptkomponente enthält, wobei der Polymerblock [B] eine Wiederholungseinheit, die von einer linearen konjugierten Dienverbindung abgeleitet ist, als Hauptkomponente enthält, und ein Verhältnis (wA:wB) eines Gewichtsanteils wA des Polymerblocks [A] in dem Blockcopolymer zu einem Gewichtsanteil wB des Polymerblocks [B] in dem Blockcopolymer 40:60 bis 60:40 beträgt.

12. Das mehrschichtige Blatt gemäß Anspruch 11, wobei die Schicht [I] aus einem schichtbildenden Material gebildet ist, das das Alkoxysilylgruppen-enthaltende hydrierte Blockcopolymer (i), und einen Lichtstabilisator vom Typ eines gehinderten Amins in einer Menge von 0,1 bis 5 Gewichtsteilen, bezogen auf 100 Gewichtsteile des Alkoxysilylgruppen-enthaltenden hydrierten Blockcopolymers (i), umfasst, und/oder die Schicht [II] aus einem schichtbildenden Material gebildet ist, das das (Co)Polymer (ii) und einen Lichtstabilisator vom Typ eines gehinderten Amins in einer Menge von 0,1 bis 5 Gewichtsteilen, bezogen auf 100 Gewichtsteile des (Co)Polymers (ii), umfasst.

13. Das mehrschichtige Blatt gemäß Anspruch 11, wobei die Schicht [I] aus einem schichtbildenden Material gebildet ist, das das Alkoxysilylgruppen-enthaltende hydrierte Blockcopolymer (i) und einen UV-Absorber in einer Menge von 0,01 bis 0,2 Gewichtsteilen, bezogen auf 100 Gewichtsteile des Alkoxysilylgruppen-enthaltenden hydrierten Blockcopolymer (i), umfasst, und/oder die Schicht [II] aus einem schichtbildenden Material gebildet ist, das das (Co)Polymer (ii) und einen UV-Absorber in einer Menge von 0,01 bis 0,2 Gewichtsteilen, bezogen auf 100 Gewichtsteile des (Co)Polymers (ii), umfasst.

14. Das mehrschichtige Blatt gemäß Anspruch 11, wobei das mehrschichtige Blatt eine Schichtkonfiguration, die die Schicht [I] und die Schicht [II] enthält, oder eine Schichtkonfiguration, die aufeinanderfolgend die Schicht [I], die Schicht [II] und die Schicht [I] enthält, aufweist.

15. Ein Verfahren zum Einschließen eines Solarzellenelements, umfassend das Anordnen des mehrschichtigen Blatts gemäß Anspruch 14, sodass die Schicht [I] des mehrschichtigen Blatts mit einer kristallinen Solarzelle in Kontakt kommt.

## Revendications

1. Copolymère séquencé hydrogéné contenant un groupe alcoxysilyle pouvant être obtenu par introduction d'un groupe alcoxysilyle dans un copolymère séquencé hydrogéné qui est obtenu par hydrogénation de 90 % ou plus des liaisons carbone-carbone insaturées de la chaîne principale, de la chaîne latérale, et du cycle aromatique d'un copolymère séquencé qui comprend au moins deux séquences polymères [A] et au moins une séquence polymère [B], la séquence polymère [A] contenant un motif de répétition dérivé d'un composé de vinyle aromatique à titre de composant principal, la séquence polymère [B] contenant un motif de répétition dérivé d'un composé de diène conjugué linéaire à titre de composant principal, le rapport (wA:wB) d'une fraction en poids wA de la séquence polymère [A] dans le copolymère séquencé à une fraction en poids wB de la séquence polymère [B] dans le copolymère séquencé étant de 20:80 à 60:40.

2. Copolymère séquencé hydrogéné contenant un groupe alcoxysilyle selon la revendication 1 pouvant être obtenu par introduction d'un groupe alcoxysilyle dans un copolymère séquencé hydrogéné qui est obtenu par hydrogénation de 90 % ou plus des liaisons carbone-carbone insaturées de la chaîne principale, de la chaîne latérale, et du cycle aromatique d'un copolymère séquencé qui comprend au moins deux séquences polymères [A] et au moins une séquence polymère [B], la séquence polymère [A] contenant un motif de répétition dérivé d'un composé de vinyle aromatique à titre de composant principal, la séquence polymère [B] contenant un motif de répétition dérivé d'un composé de diène conjugué linéaire à titre de composant principal, le rapport (wA:wB) d'une fraction en poids wA de la séquence polymère [A] dans le copolymère séquencé à une fraction en poids wB de la séquence polymère [B] dans le copolymère séquencé étant de 40:60 à 60:40.

3. Méthode de production du copolymère séquencé hydrogéné contenant un groupe alcoxysilyle selon la revendication 1, la méthode comprenant la réaction d'un composé de silane à insaturation éthylénique avec un copolymère séquence hydrogéné en présence d'un peroxyde organique, le copolymère séquencé hydrogéné étant obtenu par hydrogénation de 90 % ou plus des liaisons carbone-carbone insaturées de la chaîne principale, de la chaîne latérale, et du cycle aromatique d'un copolymère séquencé qui comprend au moins deux séquences polymères [A] et au moins une séquence polymère [B], la séquence polymère [A] contenant un motif de répétition dérivé d'un composé de vinyle aromatique à titre de composant principal, la séquence polymère [B] contenant un motif de répétition dérivé d'un composé de diène conjugué linéaire à titre de composant principal, le rapport (wA:wB) d'une fraction en poids wA de la séquence polymère [A] dans le copolymère séquencé à une fraction en poids wB de la séquence polymère [B] dans le copolymère séquencé étant de 20:80 à 60:40.

4. Méthode selon la revendication 3, dans laquelle le composé de silane à insaturation éthylénique est au moins un composé de silane à insaturation éthylénique choisi dans le groupe constitué par le triméthoxysilane de vinyle, le triéthoxysilane de vinyle, le triméthoxysilane d'allyle, le triéthoxysilane d'allyle, le vinylsilane de diméthoxyméthyle, le vinylsilane de diéthoxyméthyle, le triméthoxysilane de p-styryle, et le triéthoxysilane de p-styryle.

5. Matériau d'encapsulation d'élément de cellule solaire comprenant le copolymère séquencé hydrogéné contenant un groupe alcoxysilyle selon la revendication 1 ou 2.

6. Matériau d'encapsulation d'élément de cellule solaire selon la revendication 5, comprenant en outre un stabilisant lumière de type amine encombrée en une quantité de 0,1 à 10 parties en poids pour 100 parties en poids du copolymère séquencé hydrogéné contenant un groupe alcoxysilyle.

7. Matériau d'encapsulation d'élément de cellule solaire selon la revendication 5, comprenant en outre un absorbant UV en une quantité de 0,01 à 0,1 partie en poids pour 100 parties en poids du copolymère séquencé hydrogéné contenant un groupe alcoxysilyle.

8. Matériau d'encapsulation d'élément de cellule solaire selon la revendication 5, comprenant en outre un antioxydant à base de phosphore en une quantité de 0,01 à 0,1 partie en poids pour 100 parties en poids du copolymère séquencé hydrogéné contenant un groupe alcoxysilyle.

9. Feuille comprenant le matériau d'encapsulation d'élément de cellule solaire selon l'une quelconque des revendications 5 à 8.

10. Feuille stratifiée comprenant une feuille qui est à base d'une composition de résine, et la feuille selon la revendication 9 qui est empilée d'un seul côté ou de chaque côté de la feuille à base de la composition de résine, la composition de résine contenant (α) un copolymère séquence hydrogéné, et (β) au moins un composant choisi dans le groupe constitué par un polymère autre que le copolymère séquencé hydrogéné (α) qui contient un groupe alcoxysilyle, un stabilisant lumière, un absorbant UV, et un antioxydant, le copolymère séquencé hydrogéné étant obtenu par hydrogénation de 90 % ou plus des liaisons carbone-carbone insaturées de la chaîne principale, de la chaîne latérale, et du cycle aromatique d'un copolymère séquencé qui comprend au moins deux séquences polymères [A] et au moins une séquence polymère [B], la séquence polymère [A] contenant un motif de répétition dérivé d'un composé de vinyle aromatique à titre de composant principal, la séquence polymère [B] contenant un motif de répétition dérivé d'un composé de diène conjugué linéaire à titre de composant principal, le rapport (wA:wB) d'une fraction en poids wA de la séquence polymère [A] dans le copolymère séquencé à une fraction en poids wB de la séquence polymère [B] dans le copolymère séquencé étant de 20:80 à 60:40.

11. Feuille multicouche comprenant [I] une couche qui contient un copolymère séquencé hydrogéné contenant un groupe alcoxysilyle (i), et [II] une couche qui contient un (co)polymère (ii) qui est obtenu par introduction d'un groupe alcoxysilyle dans un (co)polymère qui a un point de fusion de 90 à 140 °C et est obtenu par polymérisation d'éthylène et/ou d'une α-oléfine ayant de 3 à 10 atomes de carbone, le copolymère séquencé hydrogéné contenant un groupe alcoxysilyle (i) pouvant être obtenu par introduction d'un groupe alcoxysilyle dans un copolymère séquencé hydrogéné qui est obtenu par hydrogénation de 90 % ou plus des liaisons carbone-carbone insaturées de la chaîne principale, de la chaîne latérale, et du cycle aromatique d'un copolymère séquencé qui comprend au moins deux séquences polymères [A] et au moins une séquence polymère [B], la séquence polymère [A] contenant un motif de répétition dérivé d'un composé de vinyle aromatique à titre de composant principal, la séquence polymère [B] contenant un motif de répétition dérivé d'un composé de diène conjugué linéaire à titre de composant principal, le rapport (wA:wB) d'une fraction en poids wA de la séquence polymère [A] dans le copolymère séquencé à une fraction en poids wB de la séquence polymère [B] dans le copolymère séquencé étant de 40:60 à 60:40.

12. Feuille multicouche selon la revendication 11, dans laquelle la couche [I] est à base d'un matériau formant couche qui contient le copolymère séquencé hydrogéné contenant un groupe alcoxysilyle (i), et un stabilisant lumière de type amine encombrée en une quantité de 0,1 à 5 parties en poids pour 100 parties en poids du copolymère séquencé hydrogéné contenant un groupe alcoxysilyle (i), et/ou la couche [II] est à base d'un matériau formant couche qui contient le (co)polymère (ii), et un stabilisant lumière de type amine encombrée en une quantité de 0,1 à 5 parties en poids pour 100 parties en poids du (co)polymère (ii).

13. Feuille multicouche selon la revendication 11, dans laquelle la couche [I] est à base d'un matériau formant couche qui contient le copolymère séquencé hydrogéné contenant un groupe alcoxysilyle (i), et un absorbant UV en une quantité de 0,01 à 0,2 partie en poids pour 100 parties en poids du copolymère séquencé hydrogéné contenant un groupe alcoxysilyle (i), et/ou la couche [II] est à base d'un matériau formant couche qui contient le (co)polymère (ii), et un absorbant UV en une quantité de 0,01 à 0,2 partie en poids pour 100 parties en poids du (co)polymère (ii).

14. Feuille multicouche selon la revendication 11, la feuille multicouche ayant une configuration de couches qui contient la couche [I] et la couche [II], ou une configuration de couches qui contient séquentiellement la couche [I], la couche [II], et la couche [I].

15. Méthode d'encapsulation d'un élément de cellule solaire comprenant l'agencement de la feuille multicouche selon la revendication 14 de façon que la couche [I] de la feuille multicouche soit en contact avec une cellule solaire cristalline.
